# EUROPÄISCHE PATENTSCHRIFT

(11) **EP 4 402 402 B1**
(45) Veröffentlichungstag und Bekanntmachung des Hinweises auf die Patenterteilung: **30.07.2025**
(21) Anmeldenummer: 22790255.8
(22) Anmeldetag: 15.09.2022
(51) Int. Cl.: F17C 7/04

(54) **SYSTEM MIT EINEM KRYOBEHÄLTER UND EINEM EINSTÜCKIGEN DRUCKMANAGEMENTSYSTEM**
SYSTEM WITH CRYOGENIC CONTAINER AND A SINGLE-PIECE PRESSURE MANAGEMENT SYSTEM
SYSTÈME COMPRENANT UN RÉSERVOIR CRYOGÉNIQUE ET UN SYSTÈME DE GESTION DE PRESSION D'UN SEUL TENANT

(30) Priorität: 15.09.2021 AT 5019021 U
(43) Veröffentlichungstag der Anmeldung: 24.07.2024
(73) Patentinhaber: Cryoshelter LH2 GmbH, 8143 Dobl-Zwaring (AT); Cryoshelter BioLNG GmbH, 8143 Dobl-Zwaring (AT)
(72) Erfinder: REBERNIK, Matthias, 8143 Dobl-Zwaring (AT)
(74) Vertreter: Schwarz & Partner Patentanwälte GmbH
(86) Internationale Anmeldenummer: PCT/EP2022/075618
(87) Internationale Veröffentlichungsnummer: WO 2023/041626

(56) Entgegenhaltungen:
- DE-A1- 4 320 556
- DE-B3- 102020 206 689
- US-A1- 2018 306 383
- US-B2- 9 640 808

## Beschreibung

Die Erfindung betrifft ein System, umfassend einen Kryobehälter, insbesondere einen LNG-Behälter oder einen Wasserstoffbehälter, und einen Wärmetauscher mit einem ersten Wärmetauscherrohr für Kryofluid, wobei eine Entnahmeleitung des Kryobehälters mit dem ersten Wärmetauscherrohr des Wärmetauschers verbunden ist.

Gemäß dem Stand der Technik können verflüssigte Gase in Behältern ("Kryobehältern") gespeichert werden, um diese als Kraftstoff für beispielsweise einen Motor zu lagern. Verflüssigte Gase sind Gase, die bei Siedetemperatur im flüssigen Aggregatzustand vorliegen, wobei die Siedetemperatur dieses Fluids druckabhängig ist. Wird eine solche kryogene Flüssigkeit in einen Kryobehälter gefüllt, so stellt sich, abgesehen von thermischen Wechselspielen mit dem Kryobehälter selbst, ein Druck entsprechend der Siedetemperatur ein.

Im Anwendungsgebiet der Fahrzeugtechnik kann das Kryofluid als Treibstoff für ein Fahrzeug dienen, zu welchem Zweck der Kryobehälter am Fahrzeug mitgeführt wird. Üblicherweise werden Kryobehälter an der Seite des Fahrzeugrahmens montiert, wo jedoch nur ein äußerst begrenzter Bauraum zur Verfügung steht. Ein im Stand der Technik oft diskutiertes Problem ist es daher, wo man Komponenten des Entnahmesystems und des Befüllsystems des Kryobehälters unterbringen soll. Insbesondere das Entnahmesystem des Kryobehälters weißt äußerst viele Komponenten auf, wie beispielsweise einen Wärmetauscher, um vom Kryobehälter entnommenes Kryofluid für die Zufuhr zu einem Motor des Fahrzeugs zu erwärmen bzw. in den gasförmigen Zustand zu bringen. Weiters ist es bekannt, dass ein sogenanntes Druckmanagementsystem im Entnahmesystem vorgesehen wird. Ein Druckmanagementsystem ist beispielsweise aus der WO 2021/026580 A1 bekannt und hat den Zweck, dass vom externen Wärmetauscher erwärmtes Kryofluid aus der Entnahmeleitung abgezweigt wird und durch einen weiteren, in den Kryobehälter ragenden Wärmetaucher rückgeführt wird, wodurch der Druck im Kryobehälter erhöht werden kann. Das Druckmanagementsystem umfasst zu diesem Zweck entweder eines oder zwei Ventile.

Die Größe der Komponenten ist jedoch nur einer der Faktoren, die den zur Verfügung stehenden Bauraum begrenzt. Ein weiterer relevanter Faktor ist die große Anzahl der Leitungen, die zwischen den Komponenten geführt werden müssen. Wenn man beispielsweise das in der EP 3 376 013 A1 offenbarte System betrachtet, sieht man, dass die benötigten Leitungen und die zugehörigen Anschlussstücke fast den gesamten zur Verfügung stehenden Bauraum an der Endkappe des Kryobehälters einnehmen.

Der große von den Leitungen eingenommene Bauraum ist jedoch nicht das einzige Problem, das bei Systemen wie in der EP 3 376 013 A1 gezeigt vorherrscht. Ein weiteres Problem ist beispielsweise, dass jedes Leitungsende bei einem Anschluss an ein Bauteil abgedichtet werden muss. Es ist ersichtlich, dass es aufgrund der Vielzahl an Verbindungsstücken häufig zu Fehlern bzw. nicht vollständig abdichtenden Verbindungen kommen kann. Die vielen Anschlüsse bzw. Verbindungsstücke bringen überdies einen hohen Druckverlust, große Kosten und einen hohen Montageaufwand mit sich.

Das Dokument US 9 640 808 B2 zeigt ein weiteres Entnahmesystem nach dem Stand der Technik.

Gleichzeitig werden die aus dem Stand der Technik Leitungen bekannten Leitungen von Fachpersonen jedoch sehr geschätzt, da sie leicht austauschbar und damit einfach wartbar sind. Überdies lassen sich individuelle Komponenten wie der Wärmetauscher leicht von den Leitungen demontieren, wodurch das System sehr modular ist.

Es ist die Aufgabe der Erfindung, das Entnahmesystem eines Kryobehälters kompakter und fehlerunanfälliger auszubilden.

Diese Aufgabe wird gelöst durch ein System, umfassend einen einstückigen Druckmanagement-Ventilblock mit zumindest einer ersten Eingangsöffnung, einer zweiten Eingangsöffnung, einer ersten Ausgangsöffnung und einer zweiten Ausgangsöffnung, wobei zumindest die erste Eingangsöffnung, die erste Ausgangsöffnung und die zweite Ausgangsöffnung im Inneren des einstückigen Druckmanagement-Ventilblocks durch einen Verbindungsdurchgang verbunden sind, wobei der Verbindungsdurchgang einen ersten eingangsseitigen Verbindungsabschnitt, einen ersten ausgangsseitigen Verbindungsabschnitt und einen zweiten ausgangsseitigen Verbindungsabschnitt umfasst, die an einem ersten Knotenpunkt zusammentreffen, wobei der einstückige Druckmanagement-Ventilblock zumindest eine nach außen offene Ventilausnehmung aufweist, wobei die Ventilausnehmung am ersten ausgangsseitigen Verbindungsabschnitt, am zweiten ausgangsseitigen Verbindungsabschnitt oder am Knotenpunkt ansetzt, wobei ein Ventil in die Ventilausnehmung des einstückigen Druckmanagement-Ventilblocks eingesetzt ist, und wobei das erste Wärmetauscherrohr mit der ersten Eingangsöffnung verbunden ist und die erste Ausgangsöffnung mit einem in den Kryobehälter ragenden weiteren Wärmetauscher verbunden ist, welcher, gegebenenfalls über ein zweites Wärmetauscherrohr des erstgenannten Wärmetauschers, mit der zweiten Eingangsöffnung des einstückigen Druckmanagement-Ventilblocks verbunden ist.

Erfindungsgemäß wird erstmals ein "einstückiges Druckmanagementsystem" geschaffen, wodurch einzelne Leitungen eingespart werden und die Anzahl an Verbindungsstellen reduziert wird, was Druckverluste reduziert und Kosten und den Montageaufwand senkt. Weiters wird die Sicherheit verbessert, da es weniger Leckagepunkte gibt. Üblicherweise benötigt ein Druckmanagementsystem zwei gesonderte Ventile, die jeweils über eine Eingangsleitung und eine Ausgangsleitung verfügen, wobei die Ventile einem T-Stück nachgeschalten sind, das mit einem Ausgang des Wärmetauschers verbunden ist. All diese Einzelkomponenten und die dazwischen befindlichen Anschlussstellen können in einem einzigen Druckmanagementsystem-Ventilblock zusammengefasst werden, der wesentlich weniger Raum einnimmt und keine internen Verbindungsstellen aufweisen muss, sodass dieser auch fehlerunanfälliger ist. Insbesondere wird mit dem Druckmanagementsystem-Ventilblock der Druckverlust minimiert, was ein enormer Vorteil ist.

Erfindungsgemäß werden somit erstmals mehrere Komponenten des Entnahmesystems zusammengefasst, was durch den Druckmanagementsystem-Ventilblock ermöglicht wird. Obwohl man annehmen würde, dass ein einstückiger Druckmanagementsystem-Ventilblock ein größeres Gewicht als die Einzelkomponenten aufweisen sollte, was gerade in der Fahrzeugtechnik als Tabu gilt, hat sich überraschenderweise herausgestellt, dass durch den Einsatz eines Druckmanagementsystem-Ventilblocks der benötigte Bauraum so weit reduziert werden kann, dass beispielsweise der Kryobehälter an sich größer ausführbar ist bzw. andere Komponenten im gewonnenen Bauraum angeordnet werden können, was die Effizient des Gesamtsystems erhöht. Überdies führt bereits die Reduktion der Leitungslängen im System dazu, dass das Entnahmesystem effizienter und mit weniger Wärmeverlust bzw. Druckverlust arbeitet, sodass bereits an dieser Stelle der Nachteil des zusätzlichen Gewichts überwunden wird. Weiters kann das Gewicht des Blocks auch noch optimiert werden z.B. wenn der Ventilblock als gegossener Block hergestellt wird, sodass insgesamt sogar ein Gewichtsvorteil gegenüber dem Stand der Technik erreicht werden kann.

Weiters hat sich überraschenderweise auch herausgestellt, dass alle von den Leitungen geschätzten Vorteilen auch bei dem erfindungsgemäßen "zusammengefassten" Druckmanagementsystem-Ventilblock erhalten bleiben. Einerseits sind individuelle Komponenten wie der Wärmetauscher genauso leicht vom Druckmanagementsystem-Ventilblock trennbar. Andererseits besteht auch kein Bedürfnis mehr, einzelne Leitungen auszuwechseln, da diese bereits unmittelbar in den Druckmanagementsystem-Ventilblock eingearbeitet sind.

Um die Komponenten des erfindungsgemäßen Systems weiter zu reduzieren, kann insbesondere vorgesehen werden, nur ein Ventil im Druckmanagementsystem-Ventilblock vorzusehen. Hierzu kann die Ventilausnehmung am Knotenpunkt des Verbindungsdurchgangs ansetzen und das Ventil als Mehrwegventil zwischen dem ersten eingangsseitigen Verbindungsabschnitt, dem ersten ausgangsseitigen Verbindungsabschnitt und dem zweiten ausgangsseitigen Verbindungsabschnitt ausgebildet sein. Anstelle von zwei Ventilen wird somit nur ein Ventil vorgesehen, das unmittelbar am Knotenpunkt ansetzt.

In der vorgenannten Ausführungsform kann beispielsweise vorgesehen werden, dass das Ventil nur drei Schaltzustände ermöglicht, wobei im ersten Schaltzustand nur die Verbindung zum ersten ausgangsseitigen Verbindungsabschnitt vollständig geschlossen ist, im zweiten Schaltzustand nur die Verbindung zum zweiten ausgangsseitigen Verbindungsabschnitt vollständig geschlossen ist und im dritten Schaltzustand sowohl die Verbindung zum ersten ausgangsseitigen Verbindungsabschnitt als auch zum zweiten ausgangsseitigen Verbindungsabschnitt vollständig geschlossen ist.

Um eine genauere Steuerung zu ermöglichen, kann alternativ vorgesehen werden, dass das Ventil dazu ausgebildet ist, die Verbindung zum ersten ausgangsseitigen Verbindungsabschnitt und die Verbindung zum zweiten ausgangsseitigen Verbindungsabschnitt selektiv zu drosseln, d.h. das Verhältnis zwischen Gasphase und Flüssigphase kann frei gewählt werden, z.B. in gegenseitiger Abhängigkeit mit beispielhaften Öffnungen (in %) von 70/30, 80/20, 90/10 etc. oder in gegenseitiger Unabhängigkeit mit beispielhaften Öffnungen (in %) von 90/90, 50/60, 10/0 etc. Jedenfalls kann jedoch vorgesehen werden, dass sowohl der erste ausgangsseitige Verbindungsabschnitt als auch der zweite ausgangsseitige Verbindungsabschnitt gleichzeitig gesperrt werden können.

Alternativ oder zusätzlich zu den vorgenannten Ausführungsformen kann das Druckmanagementsystem nicht bzw. nicht nur dadurch gebildet werden, dass ein Ventil am Knotenpunkt vorgesehenen wird, sondern dadurch, dass der einstückige Druckmanagement-Ventilblock eine erste und eine zweite nach außen offene Ventilausnehmung aufweist, wobei die erste Ventilausnehmung am ersten ausgangsseitigen Verbindungsabschnitt und die zweite Ventilausnehmung am zweiten ausgangsseitigen Verbindungsabschnitt ansetzt, wobei ein erstes Ventil in die erste Ventilausnehmung und ein zweites Ventil in die zweite Ventilausnehmung eingesetzt ist, wobei das erste und das zweite Ventil jeweils Proportionalventile oder Ventile mit diskreten Schaltzuständen sind. Im unten näher erläuterten Fall, dass die zweite Eingangsöffnung mit dem zweiten ausgangsseitigen Verbindungsabschnitt verbunden ist, ist bevorzugt, dass die zweite Ventilausnehmung zwischen dem Knotenpunkt und der Anschlussstelle der zweiten Eingangsöffnung an den zweiten ausgangsseitigen Verbindungsabschnitt an diesem ansetzt.

Die vorgenannte zweite Eingangsöffnung dient dazu, das über die erste Ausgangsöffnung zum internen Wärmetauscher geführte Kryofluid in kompakter Art und Weise wieder in die Entnahmeleitung rückzuführen. Der Anschluss der zweiten Eingangsöffnung an die Anschlussleitung zum Motor kann auf zwei unterschiedliche Arten ermöglicht werden.

Erstens kann die zweite Eingangsöffnung innerhalb des Druckmanagement-Ventilblocks über einen zweiten eingangsseitigen Verbindungsabschnitt mit dem zweiten ausgangsseitigen Verbindungsabschnitt verbunden sein oder der Druckmanagement-Ventilblock kann eine dritte Ausgangsöffnung umfassen, wobei die zweite Eingangsöffnung innerhalb des Druckmanagement-Ventilblocks über einen weiteren Verbindungsdurchgang mit der dritten Ausgangsöffnung verbunden ist, wobei der weitere Verbindungsdurchgang nicht mit dem vorgenannten Verbindungsdurchgang in Verbindung steht. Die letztgenannte Ausführungsform zeichnet sich durch eine besonders einfache Herstellung des Druckmanagement-Ventilblocks aus.

Bei allen vorgenannten Ausführungsformen ist weiters vorteilhaft, dass die Ventile gleichzeitig dazu eingesetzt werden können, um einen Durchfluss vollständig zu sperren, was bei üblichen Druckmanagementsystemen nicht vorgesehen ist. Insbesondere können die Ventile über einen manuell betätigbaren Not-Aus-Schalter geschlossen werden. Alternativ können die Ventile mit einer Steuerleitung verbunden sein, welche zu einer Fahrzeugelektronik oder zu einer Steuereinheit des Kryobehälters geführt ist, wodurch die Ventile beispielsweise in einem Notfall wie einem Unfall automatisch geschlossen werden können. Dadurch kann gleichzeitig die Sicherheit des Entnahmesystems erhöht werden. Zusätzlich kann vorgesehen werden, dass die Ventile auch zusätzlich manuell gesperrt werden können z.B. im Servicefall, um der Person die Sicherheit zu geben, jede Fehlfunktion der Ventile ausschließen zu können.

Erfindungsgemäß kann nicht nur das Druckmanagementsystem und dessen Anschlüsse bzw. Verzweigungen zusammengefasst werden, sondern auch weitere Komponenten des Systems. Insbesondere wurde überraschenderweise festgestellt, dass es sogar möglich ist, alle Komponenten des Entnahmesystems, die sich zwischen dem Wärmetauscher und der Schnittstelle zum Fahrzeug, d.h. der Anschlussstelle des Kryobehälters an die Fahrzeugleitung, befinden, zusammenzufassen. Insbesondere kann der Druckmanagement-Ventilblock umfassen:
- eine weitere nach außen offene Ventilausnehmung, welche am zweiten endseitigen Verbindungsabschnitt ansetzt, wobei ein Absperrventil in die weitere Ventilausnehmung eingesetzt ist.
- eine oder mehrere nach außen offene Sensorausnehmungen für einen Sensor, welche am ersten eingangsseitigen Verbindungsabschnitt, am zweiten eingangsseitigen Verbindungsabschnitt, am ersten ausgangsseitigen Verbindungsabschnitt und/oder am zweiten ausgangsseitigen Verbindungsabschnitt ansetzen. Insbesondere kann ein Temperatursensor am zweiten ausgangsseitigen Verbindungsabschnitt ansetzen, um die Temperatur unmittelbar vor der zweiten Ausgangsöffnung zu messen, d.h. die Sensorausnehmung befindet sich zwischen dem Knotenpunkt und der zweiten Ausgangsöffnung oder zwischen einer Ventilöffnung im zweiten ausgangsseitigen Verbindungsabschnitt und der zweiten Ausgangsöffnung.

Weiters kann der einstückige Druckmanagement-Ventilblock zumindest einen weiteren Verbindungsdurchgang aufweisen, der mit keinem der vorgenannten Verbindungsdurchgänge verbunden ist, wobei der weitere Verbindungsdurchgang mit einer Eingangsleitung oder Ausgangsleitung für Wärmetauschmedium, mit dem Kryobehälter zur Entnahme von Kryofluid oder mit dem internen Wärmetauscher zur Rückführung von Kryofluid durch ein zweites Wärmetauscherrohr verbunden ist. Der Druckmanagement-Ventilblock kann auch mehrere dieser weiteren Verbindungsdurchgänge aufweisen. Es handelt sich somit um weitere, unabhängige Durchgänge, z.B. eine Durchgangsbohrung, um ein noch kompakteres Design zu erzielen. Erfindungsgemäß können somit mehrere Verbindungsdurchgänge im Druckmanagement-Ventilblock vorliegen, die nicht oder nur über die nachfolgend genannten Überbrückungsleitungen miteinander verbunden sind. In einem Spezialfall sind alle Eingänge und Ausgänge des Wärmetauschers mit Öffnungen des Druckmanagement-Ventilblocks verbunden, sodass der Wärmetauscher nur an den Druckmanagement-Ventilblock und an keine weiteren Leitungen angeschlossen werden muss.

In einer weiteren Ausführungsform kann das System ferner eine Überbrückungsleitung zum Parallelschalten des ersten Wärmetauscherrohres, eine zweite Überbrückungsleitung zum Parallelschalten eines zweiten Wärmetauscherrohres des bzw. eines externen Wärmetauschers und/oder eine Überbrückungsleitung zum Parallelschalten des internen Wärmetauschers umfassen, wobei zumindest eine der Überbrückungsleitungen innerhalb des Druckmanagement-Ventilblocks mit dem Verbindungsdurchgang oder einem weiteren Verbindungsdurchgang verbunden ist und bevorzugt eine Ventilausnehmung zur Steuerung des Massenstroms über die Überbrückungsleitung vorgesehen ist. Mittels der Überbrückungsleitungen kann ein Massenstrom an Kryofluid zu dem jeweiligen Wärmetauscherrohr parallelgeschalten werden, um eine kurzzeitige Reduktion des Druckverlustes zu erzielen, da der Druckverlust über einen Wärmetauscher in der Regel höher ist als über eine Überbrückungsleitung. Wenn die Überbrückungsleitung vollständig innerhalb des Ventilblocks geführt ist, ist diese ein Verbindungsabschnitt zwischen zwei anderen Verbindungsabschnitten. Eine Überbrückungsleitung kann jedoch auch aus dem Ventilblock geführt werden, z.B. zu einem anderen Ventilblock, sodass die Überbrückungsleitung eine Kombination aus einem oder mehreren Verbindungsabschnitten in einem bzw. mehreren Ventilblöcken und einer Zwischenleitung sein kann.

Besonders bevorzugt ist die erste Eingangsöffnung des einstückigen Druckmanagement-Ventilblocks unmittelbar ohne Zwischenleitung an das erste Wärmetauscherrohr bzw. einen ersten Ausgang des Wärmetauschers angeschlossen. Der Druckmanagement-Ventilblock kann somit unmittelbar an den Wärmetauscher angebaut werden, ohne dass eine Zwischenleitung notwendig wäre.

Wenn der Wärmetauscher nur ein Wärmetauscherrohr umfasst, kann der interne Wärmetauscher über eine Anschlussleitung unmittelbar mit der zweiten Eingangsöffnung verbunden sein. Bevorzugt ist jedoch, wenn der Wärmetauscher ein zweites Wärmetauscherrohr umfasst und wobei die zweite Eingangsöffnung des einstückigen Druckmanagement-Ventilblocks unmittelbar ohne Zwischenleitung an das zweite Wärmetauscherrohr bzw. einen zweiten Ausgang des Wärmetauschers angeschlossen ist. Dadurch kann wiederum ermöglicht werden, dass kein Raum zwischen dem Wärmetauscher und dem Druckmanagement-Ventilblock vorgesehen werden muss.

Besonders viel Platz kann eingespart werden, wenn der Wärmetauscher stabförmig mit einer Mantelfläche und zwei Seitenflächen ausgebildet ist, wobei der Druckmanagement-Ventilblock in Verlängerung des Wärmetauschers neben einer der Seitenflächen angeordnet ist.

Überraschenderweise ermöglicht der Druckmanagement-Ventilblock sogar, dass der Druckmanagement-Ventilblock eine Seitenfläche des Wärmetauschers ersetzen kann, z.B. wenn der Wärmetauscher einen Mantel umfasst, wobei der Druckmanagement-Ventilblock eine der Seitenflächen des Wärmetauschers bildet und ein erstes Ende des Mantels fluiddicht mit dem Druckmanagement-Ventilblock verbunden ist.

Im Allgemeinen könnte der Druckmanagement-Ventilblock neben einer Endkappe des Kryobehälters angeordnet sein, um dort einen Raumgewinn zu erzielen. Insbesondere bei dem vorliegenden Druckmanagement-Ventilblock bietet sich jedoch an, beide Komponenten an der Mantelfläche anzuordnen, wodurch kein zusätzlicher Platz neben dem Kryobehälter vorgesehen werden muss, wodurch dieser besonders lange ausgebildet werden kann. Zu diesem Zweck weist der Kryobehälter einen Kryobehältermantel und zwei Endkappen aufweist, wobei der Wärmetauscher im Wesentlichen parallel zum Kryobehältermantel angeordnet ist und sowohl der Wärmetauscher als auch der Druckmanagement-Ventilblock neben dem Kryobehältermantel zumidnest teilweise, bevorzugt vollständig zwischen den Außenseiten der Endkappen liegen, d.h. in Längsrichtung des Kryobehälters nicht über diesen hinausragen, wobei Anschlussleitungen seitlich des Kryobehälters leichter verbaut werden können und längsseitig über den Kryobehälter hinausragen könnten.

Alternativ oder zusätzlich könnte der Wärmetauscher und/oder der Druckmanagement-Ventilblock auch über eine der Endkappen ragen, wobei zumindest eine, bevorzugt alle der Eingangsöffnungen und/oder Ausgangsöffnungen in Richtung des Fahrzeugrahmens angeordnet sind, d.h. normal zur Längsachse des Wärmetauschers bzw. Kryobehälters liegen und zum Fahrzeugrahmen zeigen.

Weiters bevorzugt umfasst das System eine Steuereinheit, welche mit zumindest einem Ventil, bevorzugt allen Ventilen des Druckmanagement-Ventilblocks verbunden ist, wobei die Steuereinheit dazu ausgebildet ist, den Massenstrom des über den internen Wärmetauscher zurückgeführten Kryofluids zu steuern und/oder gegebenenfalls den Massenstrom über eine der Überbrückungsleitungen zu steuern. Zwar könnte die Steuerung der Ventile in manchen Fällen auch manuell erfolgen, jedoch wird eine Steuereinheit bevorzugt. Die Steuereinheit kann die Ventile derart ansteuern, dass diese die Funktion des Druckmanagementsystems übernehmen. Beispielsweise wird der den internen Wärmetauscher geführte Anteil von Kryofluid erhöht, wenn der Druck im Kryobehälter erhöht werden soll. Die Steuerung des Massenstroms über die Überbrückungsleitung erfolgt mit dem Ziel, die durch die Wärmetauscher bedingten Druckverluste temporär zu senken, z.B. wenn das dem Wärmetauscher zugeführte Wärmetauschmedium zu warm ist und dadurch das Kryofluid unnötig stark erwärmt wird oder um einen zu niedrigen Druck im Kryobehälter auszugleichen, der aufgrund einer Fehlbetankung vorliegen könnte.

In der vorgenannten Ausführungsform ist besonders bevorzugt, wenn das System zumindest einen Sensor umfasst, der bevorzugt in eine Sensorausnehmung des Druckmanagement-Ventilblocks oder eines Economizer-Ventilblocks eingesetzt ist, wobei die Steuereinheit dazu ausgebildet ist, das bzw. die Ventile in Abhängigkeit eines vom Sensor gelieferten Messwertes zu steuern. Wenn die Sensoren auch in den entsprechenden Ventilblöcken untergebracht sind, wird ein besonders kompaktes System ermöglicht.

Vorteilhafte und nicht einschränkende Ausführungsformen der Erfindung werden nachfolgend anhand der Zeichnungen näher erläutert.
Figur 1 zeigt ein Entnahmesystem und Befüllsystem eines Kryobehälters gemäß dem Stand der Technik.
Figur 2 zeigt einen Economizer-Ventilblock in einer ersten Ausführungsform.
Figur 3 zeigt den Economizer-Ventilblock von Figur 2 in einer Seitenansicht.
Figur 4 zeigt einen Economizer-Ventilblock in einer zweiten Ausführungsform.
Figur 5 zeigt einen erfindungsgemäßen Druckmanagement-Ventilblock in einer ersten Ausführungsform.
Figur 6 zeigt einen erfindungsgemäßen Druckmanagement-Ventilblock in einer zweiten Ausführungsform.
Figur 7 zeigt ein Entnahmesystem mit dem Economizer-Ventilblock und dem erfindungsgemäßen Druckmanagement-Ventilblock.
Figur 8 zeigt eine erfindungsgemäße Anordnung mit Wärmetauscher, Economizer-Ventilblock und Druckmanagement-Ventilblock in einer ersten Ausführungsform.
Figur 9 zeigt eine erfindungsgemäße Anordnung mit Wärmetauscher, Economizer-Ventilblock und Druckmanagement-Ventilblock in einer zweiten Ausführungsform.
Figur 10 zeigt einen Wärmetauscher mit einem integrierten Anschlussblock.
Figur 11 zeigt einen Wärmetauscher mit einem integrierten Druckmanagement-Ventilblock und einem integrierten Economizer-Ventilblock in einer ersten Ausführungsform.
Figur 12 zeigt einen Wärmetauscher mit einem integrierten Druckmanagement-Ventilblock und einem integrierten Economizer-Ventilblock in einer zweiten Ausführungsform.
Figur 13 zeigt die Anordnung des Wärmetauschers von Figur 12 auf einem Kryobehälter.
Figur 14 zeigt eine Ausführungsform, bei welcher der Economizer-Ventilblock und der Druckmanagement-Ventilblock zusammen in einem Ventilblock ausgeführt sind.
Figur 15 zeigt eine Variante von Figur 14 mit Überbrückungsleitungen innerhalb des Ventilblocks.

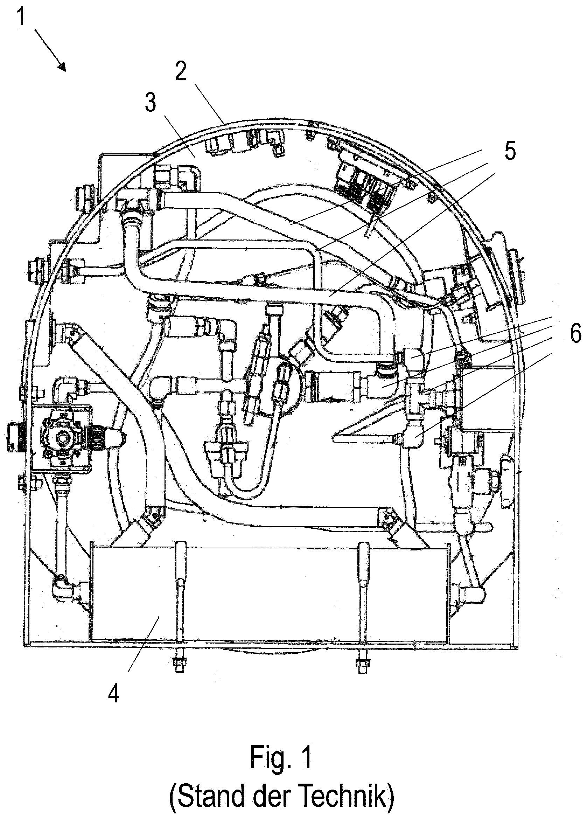

Figur 1 zeigt einen Kryobehälter 1 gemäß dem Stand der Technik in einer Seitenansicht. Der Kryobehälter 1 weist einen Kryobehältermantel 2 und eine Endkappe 3 auf. Der Kryobehältermantel 2 ist im dargestellten Beispiel zylindrisch, was aufgrund der gewählten Ansicht nur teilweise ersichtlich ist. An einer Endkappe 3 des Kryobehälters 1 ist ein Entnahmesystem angeordnet, das unter anderem einen Wärmetauscher 4, mehrere Leitungen 5 und Anschlusselemente 6 der Leitungen 5 aufweist. Die Anschlusselemente 6 sind beispielsweise T-Stücke oder Winkel.

Aus Figur 1 ist gut ersichtlich, dass die Leitungen 5 fast den gesamten Bauraum vor dem Kryobehälter 1 einnehmen, wodurch der Kryobehälter 1 kürzer ausgeführt werden muss, als grundsätzlich möglich wäre, bzw. wodurch weitere Komponenten an anderen Stellen angeordnet werden müssen. Zudem muss an jeder Schnittstelle zwischen Leitung 5 und Anschlusselement 6 eine fehleranfällige Dichtverbindung hergestellt werden.

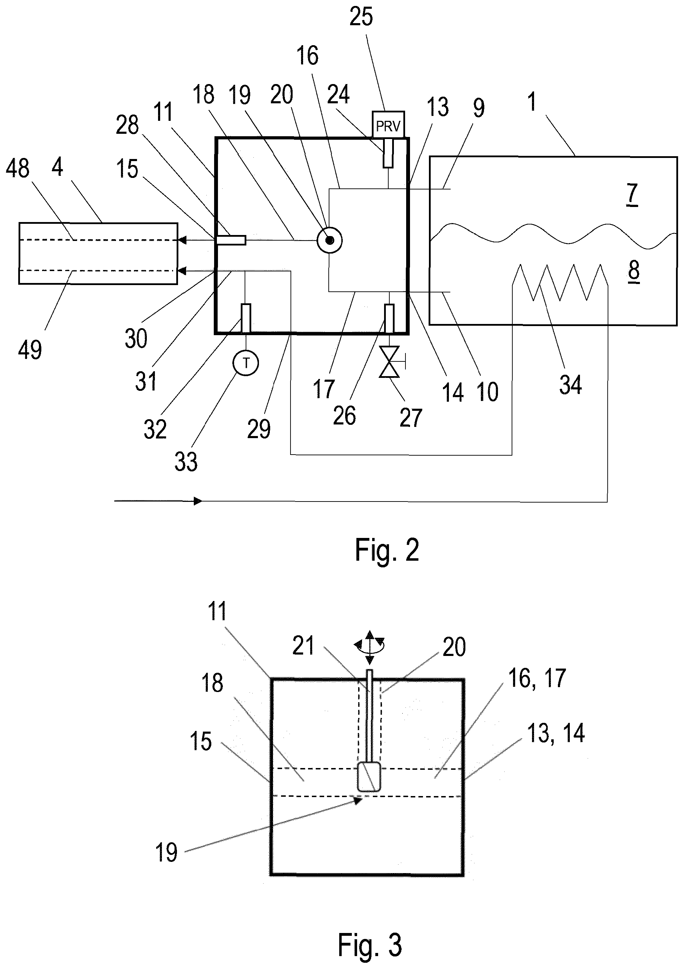

Die Figuren 2 - 13 zeigen nun ein System, mit dem der Platzbedarf reduziert wird und bei dem eine geringere Fehleranfälligkeit vorliegt. Weiters ist bei diesem System der Montageaufwand stark reduziert, der Prüfaufwand ist verringert und die Kosten werden reduziert. Da der Kryobehälter 1, dessen Kryobehältermantel 2 und Endkappen 3, und der Wärmetauscher 4 gleich oder ähnlich wie in Figur 1 ausgeführt werden können, werden gleiche Bezugszeichen verwendet.

In dem hierin betrachteten Kryobehälter 1 wird Kryofluid im gasförmigen Zustand 7 oder flüssigen Zustand 8 gelagert. Das Kryofluid kann beispielsweise Wasserstoff sein, sodass der Kryobehälter 1 ein Wasserstoffbehälter ist, oder das Kryofluid kann LNG (Liquefied Natural Gas) sein, sodass der Kryobehälter ein LNG-Behälter ist. Je nach Kryofluid ist der Kryobehälter somit dazu ausgelegt, Kryofluid bei Temperaturen von beispielsweise unter 150 Kelvin, im Fall von Wasserstoff sogar von unter 50 Kelvin oder unter 30 Kelvin oder im Wesentlichen 20 Kelvin, zu lagern. Je nach Anwendung könnte der Kryobehälter 1 beispielsweise zur Lagerung von sLH2 (subcooled liquid hydrogen) oder CcH2 (cryocompressed hydrogen) ausgebildet und damit auch für entsprechende hohe Drücke ausgelegt sein, z.B. für Maximaldrücke zwischen 5 bar und 350 bar.

Der hierin beschriebene Kryobehälter 1 wird üblicherweise als Kraftstoffbehälter eines nicht weiter dargestellten Fahrzeugs eingesetzt und kann zu diesem Zweck beispielsweise am Fahrzeugrahmen des Fahrzeugs montiert werden. Um einem Antrieb wie z.B. Motor oder Brennstoffzelle, des Fahrzeugs das Kryofluid als Kraftstoff zuzuführen, sind zwei Entnahmeleitungen 9, 10 in den Kryobehälter 1 geführt. Die erste Entnahmeleitung 9 ist zur Entnahme von gasförmigen Kryofluid in den im Betriebslage des Kryobehälters 1 oberen Bereich geführt, und die zweite Entnahmeleitung 10 ist zur Entnahme von flüssigem Kryofluid in den im Betriebslage des Kryobehälters 1 unteren Bereich geführt. Die Entnahmeleitungen 9, 10 durchsetzen entweder den Kryobehältermantel 2 oder eine der Endkappen 3 und werden so aus dem Kryobehälter 1 geführt.

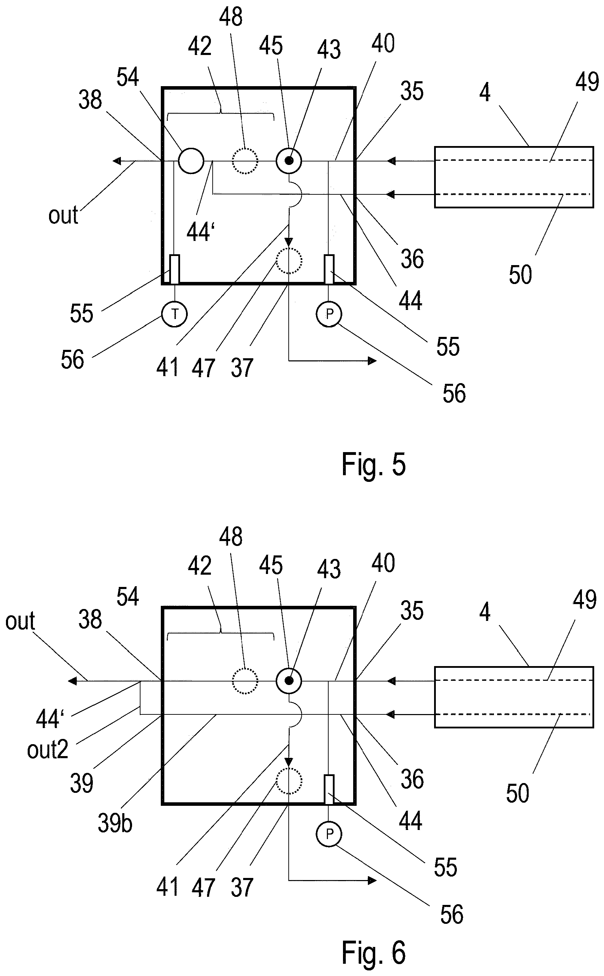

Um zu verhindern, dass ein erhöhter Platzbedarf durch Leitungen wie in Figur 1 gezeigt entsteht, werden ausgewählte Komponenten vor und/oder hinter dem Wärmetauscher 4 integriert als sogenannter Economizer-Ventilblock 11 (Figuren 2 bis 4) bzw. als sogenannter Druckmanagement-Ventilblock 12 (Figuren 5 und 6) ausgeführt.

Der Economizer-Ventilblock 11 ist als einstückiger Ventilblock ausgeführt, beispielsweise aus Edelstahl, was insbesondere bevorzugt ist, wenn das Kryofluid Wasserstoff ist, oder aus Messing. Der Economizer-Ventilblock 11 weist eine erste Eingangsöffnung 13 für die erste Entnahmeleitung 9 und eine zweite Eingangsöffnung 14 für die zweite Entnahmeleitung 10 auf. Weiters weist der Economizer-Ventilblock 11 eine Ausgangsöffnung 15 zum Anschluss an den Wärmetauscher 4 auf.

Im Inneren des Economizer-Ventilblocks 11 sind die erste Eingangsöffnung 13, die zweite Eingangsöffnung 14 und die Ausgangsöffnung 15 durch einen Verbindungsdurchgang verbunden. Der Verbindungsdurchgang setzt sich aus einem gasphasenseitigen Verbindungsabschnitt 16, einem flüssigphasenseitigen Verbindungsabschnitt 17 und einem endseitigen Verbindungsabschnitt 18 zusammen, die an einem Knotenpunkt 19 zusammentreffen.

Der Verbindungsdurchgang kann einen Durchmesser aufweisen, der dem Innendurchmesser der bekannten Leitungen 5 aus Figur 1 entspricht, wobei der Durchmesser des Verbindungsdurchgangs im Inneren des Economizer-Ventilblocks 11 auch variieren kann. Beispielsweise können die Durchmesser im gasphasenseitigen Verbindungsabschnitt 16, im flüssigphasenseitigen Verbindungsabschnitt 17 und im endseitigen Verbindungsabschnitt 18 unterschiedlich ausgebildet sein. Der Verbindungsdurchgang kann durch Bohrungen hergestellt werden oder beispielsweise unmittelbar mithergestellt werden, wenn der Economizer-Ventilblock 11 gegossen wird. Gleiches gilt für den unten näher erläuterten Druckmanagement-Ventilblock 12.

Um einen sogenannten Economizer im Economizer-Ventilblock 11 zu verwirklichen, werden ein oder mehrere Ventile im Economizer-Ventilblock 11 vorgesehen, um das Entnahmeverhältnis von Kryofluid in Flüssigphase und Gasphase zu steuern, wodurch beispielsweise der Druck im Kryobehälter 1 aktiv beeinflusst werden kann, ohne gasförmiges Kryofluid an die Umwelt abzulassen. Die Funktionsweise eines Economizers ist allgemein bekannt, sodass hierin nicht weiter darauf eingegangen wird.

Figur 2 zeigt eine Ausführungsform, bei welcher der Economizer-Ventilblock 11 eine nach außen offene Ventilausnehmung 20 aufweist, welche an Knotenpunkt 19 ansetzt. In dieser Ventilausnehmung 20 kann nun ein Ventil 21 (Figur 3) eingesetzt werden, um zu steuern, welcher Anteil von gasförmigem und flüssigem Kryofluid in den endseitigen Verbindungsabschnitt 18 und damit in den Wärmetauscher 4 gelangt. Das Ventil 21 ist in dieser Ausführungsform als Mehrwegventil ausgeführt, da es ein Öffnungsverhältnis zwischen dem gasphasenseitigen Verbindungsabschnitt 16, dem flüssigphasenseitigen Verbindungsabschnitt 17 und dem endseitigen Verbindungsabschnitt 18 bestimmt.

Figur 3 zeigt eine Möglichkeit, wie das Ventil 21 das Entnahmeverhältnis regeln kann. Unter der Annahme, dass Figur 2 eine Draufsicht des Economizer-Ventilblocks 11 darstellt, stellt Figur 3 eine Seitenansicht des Economizer-Ventilblocks 11 dar. In diesem Beispiel liegt der Verbindungsdurchgang zwischen den Öffnungen 13, 14, 15 im Wesentlichen in einer Ebene. Durch diese Ansicht fallen der gasphasenseitige Verbindungsabschnitt 16 und der flüssigphasenseitigen Verbindungsabschnitt 17 somit zusammen. Senkrecht zu der vorgenannten Ebene durchsetzt die Ventilausnehmung 20 den Economizer-Ventilblock 11 von oben nach unten, bis diese am Knotenpunkt 19 ansetzt. Das in die Ventilausnehmung 20 eingesetzte Ventil 21 kann nun - je nach Ausgestaltung - durch Drehen oder Längsversetzen steuern, in welchem Verhältnis der gasphasenseitige Verbindungsabschnitt 16 bzw. der flüssigphasenseitige Verbindungsabschnitt 17 mit dem endseitigen Verbindungsabschnitt 18 verbunden ist.

Im einfachsten Fall ermöglicht das als Mehrwegventil ausgebildete Ventil 21 nur drei Schaltzustände, wobei im ersten Schaltzustand nur die Verbindung zum gasphasenseitigen Verbindungsabschnitt 16 vollständig geschlossen ist, im zweiten Schaltzustand nur die Verbindung zum flüssigphasenseitigen Verbindungsabschnitt 17 vollständig geschlossen ist und im dritten Schaltzustand sowohl die Verbindung zum gasphasenseitigen Verbindungsabschnitt 16 als auch zum flüssigphasenseitigen Verbindungsabschnitt 17 vollständig geschlossen ist.

In anderen Fällen ist es möglich, das Mehrwegventil als Proportionalventil auszuführen, um die Verbindung zum gasphasenseitigen Verbindungsabschnitt 16 und die Verbindung zum flüssigphasenseitigen Verbindungsabschnitt 17 selektiv zu drosseln. Dadurch ist es beispielsweise möglich, die Verbindung zwischen dem gasphasenseitigen Verbindungsabschnitt 16 und dem endphasenseitigen Verbindungsabschnitt 18 um X % zu öffnen und unabhängig davon die Verbindung zwischen dem flüssigphasenseitigen Verbindungsabschnitt 17 und dem endphasenseitigen Verbindungsabschnitt 18 um 100-X % zu öffnen, wobei 0 ≤ X ≤ 100. Alternativ könnte das Mehrwegventil dazu ausgebildet sein, die Verbindung zwischen dem gasphasenseitigen Verbindungsabschnitt 16 und dem endphasenseitigen Verbindungsabschnitt 18 zwischen 0-100 % zu öffnen und unabhängig davon die Verbindung zwischen dem flüssigphasenseitigen Verbindungsabschnitt 17 und dem endphasenseitigen Verbindungsabschnitt 18 zwischen 0-100 % zu öffnen. Diese unterschiedlichen Ausführungsformen dienen dem Ziel, die Druckverluste zwischen dem Kyobehälter und dem Verbraucher (Motor) zu minimieren. Die Druckverluste gehen als nicht nutzbares Druckintervall für die Hold Time (abblasefreie Speicherdauer) verloren. Gleichzeitig will man in gewissen Betriebszuständen bewusst Druckunterschiede zwischen gewissen Leitungspfaden einstellen können.

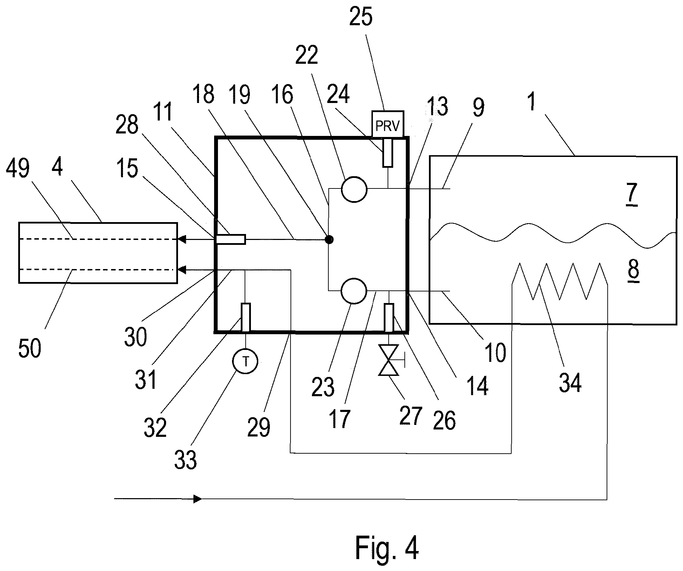

Figur 4 zeigt eine Ausführungsform, bei welcher der Economizer-Ventilblock 11 zwei nach außen offene Ventilausnehmungen 22, 23 aufweist, wobei die erste am gasphasenseitigen Verbindungsabschnitt 16 und die zweite am flüssigphasenseitigen Verbindungsabschnitt 17 ansetzt. In dieser Ausführungsform ist ein erstes Ventil (nicht dargestellt) in die erste Ventilausnehmung 22 und ein zweites Ventil (nicht dargestellt) in die zweite Ventilausnehmung 23 eingesetzt ist. Das erste und das zweite Ventil können jeweils Proportionalventile sein, d.h. abhängig oder unabhängig voneinander zwischen 0-100% geöffnet werden. Alternativ könnten die Ventile nur diskrete Schaltzustände aufweisen, z.B. nur vollständig geschlossen oder vollständig geöffnet sein und gegebenenfalls eine Zwischenstellung von beispielsweise 50 % geöffnet einnehmen.

Die Ausführungsformen der Figuren 2 bis 4 könnten auch kombiniert werden, d.h. es könnten nach außen offene Ventilausnehmungen 20, 22, 23 am Knotenpunkt 19, am gasphasenseitigen Verbindungsabschnitt 16 und am flüssigphasenseitigen Verbindungsabschnitt 17 ansetzen, wobei Ventile in alle drei Ventilausnehmungen eingesetzt sind und alle drei Ventile beispielsweise gesondert steuerbar sind.

Wie aus den Figuren 2 und 4 ersichtlich ist, kann der Economizer-Ventilblock 11 jedoch nicht nur den Economizer innerhalb eines einstückigen Ventilblocks ausführen, sondern im Economizer-Ventilblock 11 können noch mehr Elemente integriert sein, damit beispielsweise weniger T-Stücke oder dergleichen in die Entnahmeleitungen 9, 10 eingebaut werden müssen.

Wie in Figur 2 gezeigt, kann der der Economizer-Ventilblock 11 beispielsweise eine weitere nach außen offene Ventilausnehmung 24 aufweisen kann, welche am gasphasenseitigen Verbindungsabschnitt 16 ansetzt, wobei ein Überdruckventil 25 mit der weiteren Ventilausnehmung 24 verbunden ist, beispielsweise in diese eingesetzt ist. Das Überdruckventil 25 dient dazu, bei einem Druckanstieg im Kryobehälter 1 gasförmiges Kryofluid aus diesem auszulassen, um die Gefahr einer Beschädigung des Kryobehälters 2 zu reduzieren. Es ist daher üblicherweise vorgesehen, dass das Überdruckventil 25 am gasphasenseitigen Verbindungsabschnitt 16 vor der Ventilausnehmung 20 bzw. 22 ansetzt und nicht nach der Ventilausnehmung 20 bzw. 22, da das Ventil 21 beispielsweise durch eine Fehlfunktion geschlossen sein könnte, wodurch der Kryobehälter 1 nicht mehr mit dem Überdruckventil 25 verbunden wäre. Das Überdruckventil 25 kann unmittelbar in die weitere Ventilausnehmung 24 eingesetzt sein oder mittels einer Verbindungsleitung mit der weiteren Ventilausnehmung 24 verbunden sein.

Figur 2 zeigt weiters, dass der Economizer-Ventilblock 11 eine nach außen offene Anschlussausnehmung 26 für einen Entleeranschluss 27 aufweisen kann, wobei die Anschlussausnehmung 26 mit dem flüssigphasenseitigen Verbindungsabschnitt 17 verbunden ist, d.h. es ist ein weiterer Verbindungsdurchgang vorgesehen, der die Anschlussausnehmung 26 mit dem flüssigphasenseitigen Verbindungsabschnitt 17 verbindet. Der Entleeranschluss 27 dient dazu, den Kryobehälter 1 manuell zu Entleeren, ohne das Kryofluid durch die nachgeordneten Komponenten wie den Wärmetauscher 4 führen zu müssen.

Weiters kann der endseitige Verbindungsabschnitt 18 eine Ausnehmung für ein Überströmventil 28 aufweisen, wobei die Ausnehmung zur leichteren Einbringung des Überströmventils 28 unmittelbar an die Außenwand des Economizer-Ventilblocks 11 angrenzen kann. Das Überströmventil 28 hat die Funktion, den maximalen Durchfluss durch den endseitigen Verbindungsabschnitt 18 zu begrenzen, damit Kryofluid bei einem Gebrechen des Entnahmesystems nicht unkontrolliert ausströmen kann.

Besonders relevant und spezifisch für den Economizer-Ventilblock 11 ist, dass dieser auch eine weitere Eingangsöffnung 29 und eine weitere Ausgangsöffnung 30 umfassen kann, die durch einen weiteren Verbindungsdurchgang 31 verbunden sind, wobei der weitere Verbindungsdurchgang 31 nicht mit dem erstgenannten Verbindungsdurchgang in Verbindung steht. Dieser weitere Verbindungsdurchgang 31 hat den Hintergrund, dass aufgrund des äußerst geringen zur Verfügung stehenden Bauraumes, insbesondere bei Fahrzeugen, zwischen dem Economizer-Ventilblock 11 und dem Wärmetauscher 4 nur sehr wenig Raum zur Verfügung stehen kann. Es wäre dabei beispielsweise nicht immer möglich, eine eigene, gewinkelte Leitung zwischen dem Economizer-Ventilblock 11 und dem Wärmetauscher 4 zu führen, was jedoch nicht nötig ist, wenn der Economizer-Ventilblock 11 den genannten weiteren Verbindungsdurchgang 31 aufweist. Diese Ausführungsform ist somit besonders bevorzugt, wenn der Wärmetauscher 4 und der Economizer-Ventilblock 11 in einem Abstand von maximal 10 cm, bevorzugt 5 cm, besonders bevorzugt 3 cm zueinander liegen.

Weiters kann der Economizer-Ventilblock 11 eine oder mehrere nach außen offene Sensorausnehmungen 32 für einen Sensor 33 aufweisen, welche am gasphasenseitigen Verbindungsabschnitt 16, am flüssigphasenseitigen Verbindungsabschnitt 17, am endseitigen Verbindungsabschnitt 18 und/oder am weiteren Verbindungsdurchgang 31 ansetzen. Der Sensor ist bevorzugt ein Drucksensor und/oder ein Temperatursensor und kann unmittelbar oder mittelbar über eine Leitung mit der Sensorausnehmung 32 verbunden sein. Im Beispiel von Figur 2 ist die Sensorausnehmung 32 mit dem weiteren Verbindungsdurchgang 31 verbunden und ein als Temperatursensor ausgebildeter Sensor 33 ist unmittelbar an die Sensorausnehmung 32 angeschlossen. Die Anbringung eines Sensors 33 an den weiteren Verbindungsdurchgang 31 ist besonders bevorzugt, da die Messung der Temperatur bzw. des Drucks eines durch den weiteren Verbindungsdurchgang 31 rückgeführten Kryofluids von besonderer Relevanz ist, wie unten für das Druckmanagementsystem genauer erläutert ist.

Die Figuren 5 und 6 zeigen, dass auch die dem Wärmetauscher 4 nachgeschaltenen Komponenten innerhalb eines einstückigen Ventilblocks, dem sogenannten Druckmanagement-Ventilblock 12, integriert werden können. Die Ausführung des Druckmanagement-Ventilblocks 12 ist im Wesentlichen unabhängig von der Ausführung des Economizer-Ventilblocks 11. Während der Economizer-Ventilblock 11 einen Economizer implementiert, soll der Druckmanagement-Ventilblock 12 ein sogenanntes Druckmanagementsystem in einem einzigen einstückigen Ventilblock integrieren. Bei einem Druckmanagementsystem wird in allgemein bekannter Weise ein Teil des Kryofluids nach dem Wärmetauscher 4 abgezweigt und in einen weiteren, internen Wärmetauscher 34 mit einem dritten Eingang E3 und einem dritten Ausgang A3 geführt, wobei der interne Wärmetauscher 34 in den Kryobehälter 1 hineinragt. Das Abzweigen eines Teilstromes von Kryofluid kann beispielsweise durch eine gezielte Erzeugung einer Druckdifferenz zwischen den Leitungen erfolgen, wie z.B. in der WO 2021/026580 A1 beschrieben ist. Auch das Druckmanagementsystem ist allgemein bekannt, sodass hier nicht weiter darauf eingegangen wird.

Der in den Figuren 5 und 6 gezeigte Wärmetauscher 4 entspricht im Wesentlichen jenem der Figuren 2 und 4. Aus dem Kryobehälter 1 entnommenes Kryofluid durchströmt daher zuerst den Economizer-Ventilblock 11, danach den Wärmetauscher 4 und danach den Druckmanagement-Ventilblock 12.

Der Druckmanagement-Ventilblock 12 umfasst zumindest eine erste Eingangsöffnung 35, eine zweite Eingangsöffnung 36, eine erste Ausgangsöffnung 37 und eine zweite Ausgangsöffnung 38. In der Ausführungsform von Figur 5 sind alle vier Öffnungen 35, 36, 37, 38 im Inneren des Druckmanagement-Ventilblocks 12 durch einen Verbindungsdurchgang miteinander verbunden. Die zweite Ausgangsöffnung 38 ist mit einer Ausgangsleitung out verbunden, die zu einem Verbraucher, z.B. einem Motor oder einer Brennstoffzelle, des Fahrzeugs geführt sein kann.

In der Ausführungsform von Figur 6 sind nur die erste Eingangsöffnung 35, die erste Ausgangsöffnung 37 und eine zweite Ausgangsöffnung 38 durch einen Verbindungsdurchgang miteinander verbunden. Die zweite Eingangsöffnung 36 ist mit einer dritten Ausgangsöffnung 39 über einen weiteren Verbindungsdurchgang 39b verbunden, der nicht mit dem vorgenannten Verbindungsdurchgang in Verbindung steht. Eine Zwischenleitung out2 schließt an der dritten Ausgangsöffnung 39 an und verbindet diese mit der Ausgangsleitung out an einem zweiten Knotenpunkt 44'.

In beiden vorgenannten Ausführungsformen der Figuren 5 und 6 umfasst der Verbindungsdurchgang, der die Öffnungen 35, 37 und 38 verbindet, einen ersten eingangsseitigen Verbindungsabschnitt 40, einen ersten ausgangsseitigen Verbindungsabschnitt 41 und einen zweiten ausgangsseitigen Verbindungsabschnitt 42, die an einem Knotenpunkt 43 aufeinandertreffen. Der erste eingangsseitige Verbindungsabschnitt 40 erstreckt sich zwischen der ersten Eingangsöffnung 35 und dem Knotenpunkt 43, der erste ausgangsseitige Verbindungsabschnitt 41 erstreckt sich zwischen der ersten Ausgangsöffnung 37 und dem Knotenpunkt 43 und der zweite ausgangsseitige Verbindungsabschnitt 42 erstreckt sich zwischen der zweiten Ausgangsöffnung 38 und dem Knotenpunkt 43. In der Ausführungsform der Figur 5 ist die zweite Eingangsöffnung 36 innerhalb des Druckmanagement-Ventilblocks 12 über einen zweiten eingangsseitigen Verbindungsabschnitt 44 mit dem zweiten ausgangsseitigen Verbindungsabschnitt 42 an einem zweiten Knotenpunkt 44' verbunden, wobei sich der zweite ausgangsseitige Verbindungsabschnitt 42 zwischen der zweiten Eingangsöffnung 36 und dem zweiten Knotenpunkt 44' am den zweiten ausgangsseitigen Verbindungsabschnitt 42 erstreckt. Der zweite Knotenpunkt 44'liegt stromabwärts des erstgenannten Knotenpunktes 43.

Um die Funktion des Druckmanagementsystems zu implementierten, weist der Druckmanagement-Ventilblock 12 zumindest eine nach außen offene Ventilausnehmung 45 auf, wobei die Ventilausnehmung 45 am ersten ausgangsseitigen Verbindungsabschnitt 41, am zweiten ausgangsseitigen Verbindungsabschnitt 42 oder am Knotenpunkt 43 ansetzt.

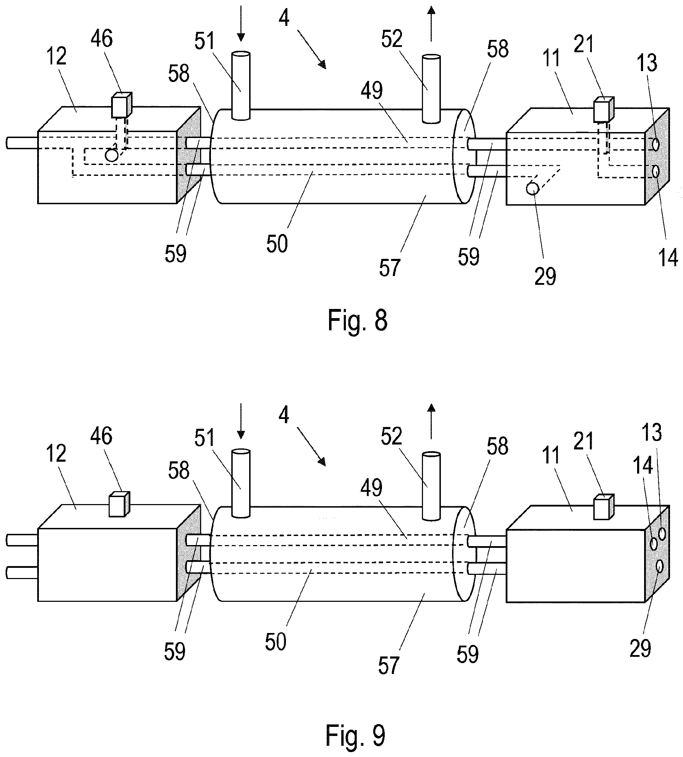

In Figur 5 setzt die Ventilausnehmung 45 am Knotenpunkt an. In die Ventilausnehmung 45 ist ein Ventil 46 eingesetzt (Figur 8), das in dieser Ausführungsform als Mehrwegventil ausgeführt, beispielsweise wie in Figur 3 dargestellt, da es ein Öffnungsverhältnis zwischen dem ersten eingangsseitigen Verbindungsabschnitt 40, dem ersten ausgangsseitigen Verbindungsabschnitt 41 und dem zweiten ausgangsseitigen Verbindungsabschnitt 42 bestimmt. Das Ventil 46 kann genauso ausgebildet sein, wie es oben für das Ventil 21 beschrieben wurde.

Alternativ oder zusätzlich kann vorgesehen werden, dass weitere Ventilausnehmungen 47, 48 am ersten ausgangsseitigen Verbindungsabschnitt 41 und/oder am zweiten ausgangsseitigen Verbindungsabschnitt 42 ausgeführt werden. In dieser Ausführungsform können ein erstes Ventil (nicht dargestellt) in die Ventilausnehmung 47 und ein zweites Ventil (nicht dargestellt) in die Ventilausnehmung 48 eingesetzt werden. Es ist hier jedoch auch möglich, eine starre Drossel in eine der Ventilausnehmungen 47, 48 einzusetzen.

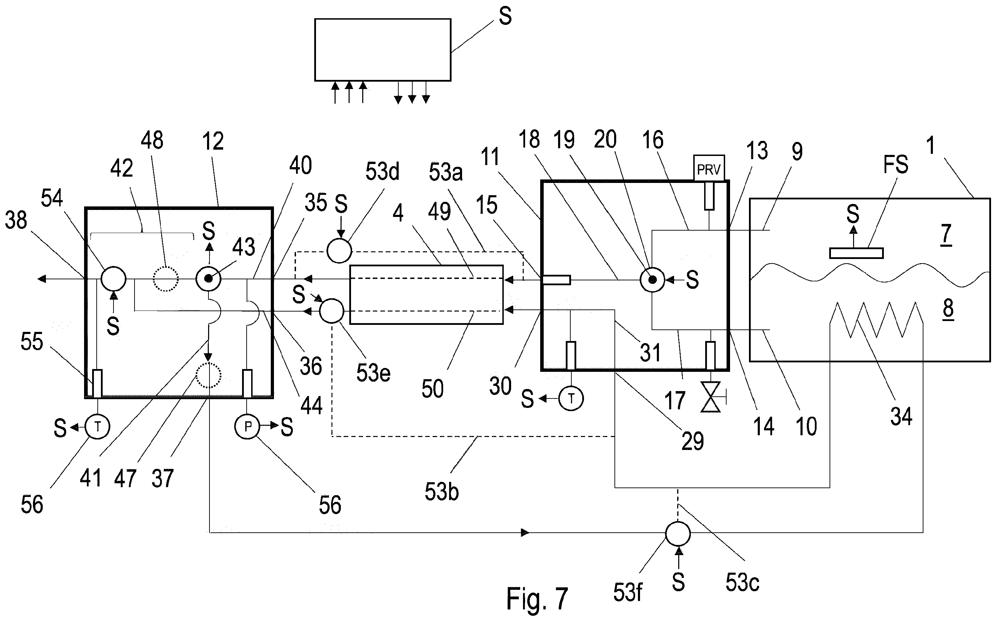

Die Funktionsweise des im Druckmanagement-Ventilblock 12 implementierten Druckmanagementsystems wird nun anhand der Figur 7 erläutert, in der die Ausführungsformen der Figuren 2 und 5 kombiniert sind. Es versteht sich jedoch, dass zur Erzielung der Funktion auch jede der anderen Ausführungsformen kombiniert werden könnte, auch ohne Economizer, d.h. ohne Economizer-Ventil 11.

Gemäß Figur 7 wird über die Entnahmeleitungen 9, 10 entnommenes Kryofluid durch den Economizer-Ventilblock 11 geführt und danach dem Wärmetauscher 4 zugeführt, der hierfür ein internes erstes Wärmetauscherrohr 49 mit einem ersten Eingang E1 und einem ersten Ausgang A1 umfasst, welches von Wärmetauschmedium umspült wird, wie unten näher erläutert. Dadurch wird das Kryofluid erwärmt und gegebenenfalls in einen gasförmigen Zustand gebracht. Sollten die Temperaturverhältnisse bzw. Druckverhältnisse des Kryofluids für die Zufuhr an den Motor geeignet sein und der Druck im Kryobehälter 1 einem Normaldruck entsprechen, kann das bzw. die Ventile 46 in den Ventilausnehmungen 45, 47, 48 den ersten ausgangsseitigen Verbindungsabschnitt 41 absperren, sodass das gesamte in den ersten eingangsseitigen Verbindungsabschnitt 40 eingebrachte Kryofluid dem zweiten ausgangsseitigen Verbindungsabschnitt 42 zugeführt wird.

Sollte jedoch gewünscht sein, den Druck im Kryobehälter 1 zu erhöhen und/oder die Temperatur des dem Motor zugeführten Gases zu beeinflussen, wird bzw. werden die Ventile 46 derart eingestellt, dass zumindest ein Teil des Kryofluids vom eingangsseitigen Verbindungsabschnitt 40 zum ersten ausgangsseitigen Verbindungsabschnitt 41 verbracht wird. Auf diesem Weg wird das Kryofluid durch den internen Wärmetauscher 34 geführt, wodurch der Druck im Kryobehälter 1 steigt. Danach wird das Kryofluid gegebenenfalls durch ein zweites Wärmetauscherrohr 50 des Wärmetauschers 4 geführt, um es wieder zu erwärmen. Danach wird das Kryofluid in die zweite Eingangsöffnung 36 des Druckmanagement-Ventilblocks 12 geführt. Das zweite Wärmetauscherrohr 50 hat einen zweiten Eingang E2 und einen zweiten Ausgang A2 und wird üblicherweise vom selben Wärmetauschmedium umspült wie das erste Wärmetauscherrohr 49. Je nach Ausführungsform kann das zweite Wärmetauscherrohr 50 auch von einem anderen Wärmetauschmedium umspült werden als das erste Wärmetauscherrohr 49, sodass de facto zwei gesonderte externe Wärmetauscher vorliegen, die zur einfacheren Betrachtung jedoch zusammen als externer Wärmetauscher 4 bezeichnet werden.

Der Wärmetauscher 4 hat somit zwei voneinander unabhängige Wärmetauschwege durch die beiden gesonderten Wärmetauscherrohre, die jeweils vom Wärmetauschmedium umspült werden, welches über einen Mediumeingang 51 in den Wärmetauscher 4 eingebracht wird und über einen Mediumausgang 52 aus diesem ausgebracht wird (Figur 8). Das Wärmetauschmedium kann beispielsweise Luft, Gas, Wasser oder Öl sein, wobei die Wärme des Wärmetauschmediums bevorzugt aus der Abwärme des Motors erzielt wird.

In einer weiteren Ausführungsform könnte aber auch vorgesehen werden, dass der Wärmetauscher 4 nur das erste Wärmetauscherrohr 49 umfasst, wenn eine Ausgangsleitung vom internen Wärmetauscher 34 unmittelbar zur zweiten Eingangsöffnung 36 des Druckmanagement-Ventilblocks 12 geführt ist.

Wie der Economizer-Ventilblock 11 kann auch der Druckmanagement-Ventilblock 12 weitere Funktionen implementieren. Insbesondere kann der Druckmanagement-Ventilblock 12 eine weitere nach außen offene Ventilausnehmung 54 aufweisen, welche am zweiten endseitigen Verbindungsabschnitt 42 ansetzt, wobei ein Absperrventil (nicht dargestellt) in die weitere Ventilausnehmung 54 eingesetzt ist, das beispielsweise über eine Steuereinheit angesteuert und in einem Notfall von dieser schließbar ist.

Weiters kann der Druckmanagement-Ventilblock 12 eine oder mehrere nach außen offene Sensorausnehmungen 55 für Sensoren 56 aufweisen, welche am ersten eingangsseitigen Verbindungsabschnitt 40, am zweiten eingangsseitigen Verbindungsabschnitt 44, am ersten ausgangsseitigen Verbindungsabschnitt 41 und/oder am zweiten ausgangsseitigen Verbindungsdurchgang 42 ansetzen. Der Sensor ist bevorzugt ein Drucksensor und/oder ein Temperatursensor und kann unmittelbar oder mittelbar über eine Leitung mit der Sensorausnehmung 55 verbunden sein. Im Beispiel von Figur 5 ist eine erste Sensorausnehmung 55 mit dem ersten eingangsseitigen Verbindungsdurchgang 40 verbunden und ein als Drucksensor ausgebildeter Sensor 56 ist unmittelbar an die Sensorausnehmung 55 angeschlossen. Weiters ist eine zweite Sensorausnehmung 55 mit dem zweiten ausgangsseitigen Verbindungsdurchgang 42 verbunden und ein als Temperatursensor ausgebildeter Sensor 56 ist unmittelbar an die Sensorausnehmung 55 angeschlossen.

Aus Figur 7 ist weiters ersichtlich, dass das System eine Steuereinheit S umfassen kann, die Messwerte von den Sensoren 33, 56 und von einem Füllstandsensor FS im Kryobehälter 1 erhalten kann und in Abhängigkeit davon die Ventile 21, 46 bzw. die weiteren in den beschriebenen Ventilausnehmungen befindlichen Ventile ansteuern kann. In Figur 7 sind Steuerleitungen zwischen der Steuereinheit S und den Sensoren bzw. Ventilen durch Pfeile in Kombination mit dem Bezugszeichen S angedeutet. Die Steuereinheit S ist nicht auf die Gesamtkombination beschränkt, sondern kann auch nur den Economizer oder nur das Druckmanagement bzw. einzelne Ventile davon steuern.

Unter Bezugnahme auf die Figuren 8 bis 13 wird nun die Anordnung des Economizer-Ventilblocks 11 bzw. des Druckmanagement-Ventilblocks 12 in Relation zum Wärmetauscher 4 erläutert. Soweit es nicht ausdrücklich beschrieben ist, ist es nicht zwingend, dass die Anordnung des Economizer-Ventilblocks 11 nur im Zusammenhang mit dem Druckmanagement-Ventilblock 12, oder umgekehrt, vorgesehen werden muss.

Aus den Figuren 8 bis 13 ist ersichtlich, dass der Wärmetauscher 4 im Wesentlichen stabförmig sein kann. In den Figuren 8 und 9 umfasst der Wärmetauscher 4 beispielsweise einen Mantel 57 und zwei Seitenflächen 58. Derartige Wärmetauscher sind aus dem Stand der Technik an sich bekannt. Der Mantel 57 ist üblicherweise zylindrisch, kann aber auch eine andere Form einnehmen und beispielsweise an die Form des Kryobehälters angepasst werden, um diesen z.B. flächig auf die Mantelfläche des Kryobehälters 2 aufzulegen. Die Seitenflächen 58 sind üblicherweise ebene Platten. Die Anschlussöffnungen des Wärmetauschers 4 für die Wärmetauscherrohre 49, 50 befinden sich üblicherweise in den Seitenflächen 58 und der Mediumeingang 51 und der Mediumausgang 52 befinden sich üblicherweise im Mantel 57. Der Mantel 57 und die Seitenflächen 58 schließen somit einen Raum ein, in dem sich das bzw. die Wärmetauscherrohre 49, 50 befinden, wobei dieser Raum in der Regel nur über den Mediumeingang 51 bzw. den Mediumausgang 52 zugänglich ist.

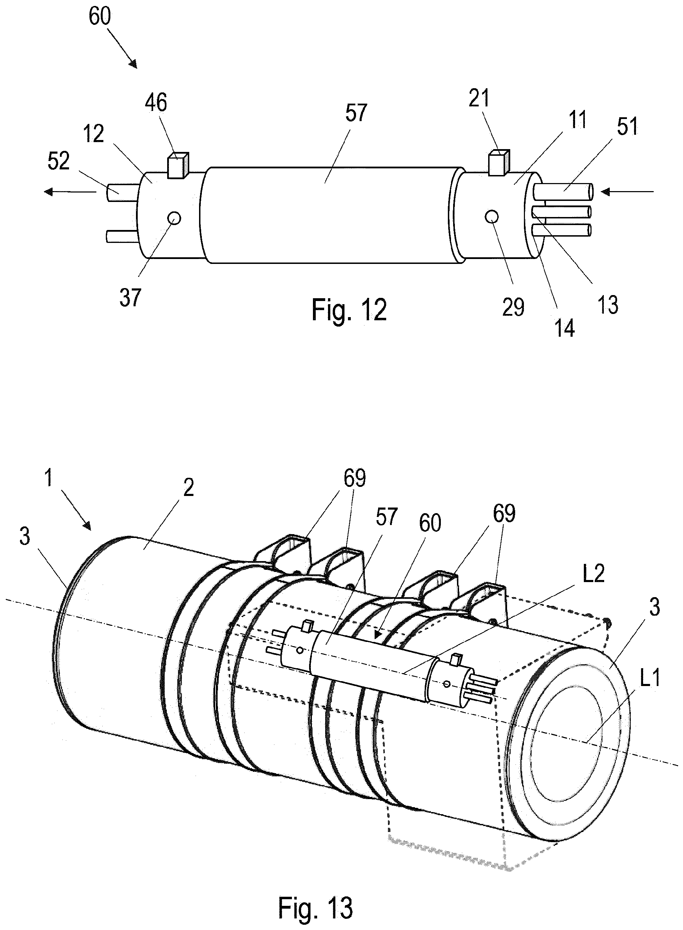

Wie in den Figuren 8 und 9 dargestellt können der Economizer-Ventilblock 11 und der Druckmanagement-Ventilblock 12, oder zumindest einer davon, in Verlängerung der Stabform des Wärmetauschers 4 angeordnet werden, d.h. jeweils ein Ventilblock 11, 12 neben einer der Seitenflächen 58, wodurch sich eine lineare Anordnung ergibt, mit dem Wärmetauscher 4 in der Mitte. Dadurch kann die Anordnung besonders schlank gewählt werden, wodurch der zur Verfügung stehende Bauraum (siehe beispielsweise Figur 13) besonders effizient ausgenutzt werden kann und die Druckverluste vom Kryobehälter bis zum Verbraucher (Motor, Brennstoffzelle) minimiert werden können. Die Seitenflächen 58 des Wärmetauschers 4 liegen dabei bevorzugt parallel zu einer der Seitenflächen des Economizer-Ventilblocks 11 und/oder des Druckmanagement-Ventilblocks 12.

In der Ausführungsform von Figur 8 liegen - wie in den Figuren 2 bis 7 angedeutet - einige der Anschlussöffnungen an einer Seite des jeweiligen Ventilblocks 11, 12 und andere Anschlussöffnungen liegen an einer anderen, normal zu dieser befindlichen Seite. Um die Anschlussleitungen möglichst effizient zu verlegen, können wie in Figur 9 alle Öffnungen an einer Seite des jeweiligen Ventilblocks 11, 12 angeordnet werden, die entweder dem Wärmetauscher 4 zugewandt oder abgewandt sind. Die Richtung der Ausgänge, z.B. in den Ventilblöcken 11, 12, kann auch gleich so angeordnet sein, dass diese z.B. im rechten Winkel zur Längsachse des Wärmetauschers 4 liegen, um ein einfaches Anbinden des Kryobehälters an das Fahrzeug zu ermöglichen, wodurch beispielsweise ein 90° Winkel eingespart werden kann.

Weiters zeigen die Figuren 8 und 9, dass die Ventilblöcke 11, 12 im Wesentlichen rechteckig sein können und der Wärmetauscher 4 im Wesentlichen zylindrisch sein kann. Bevorzugt haben die Ventilblöcke 11, 12 und der Wärmetauscher 4 jedoch eine im Wesentlichen selbe Form im Querschnitt zu einer Längsachse des Wärmetauschers 4, sodass diese deckungsgleich angeordnet werden können.

Aus den Figuren 8 und 9 ist ersichtlich, dass die Ventilblöcke 11, 12 nicht unmittelbar an den Kryobehälter 1 angeschlossen sind, sondern dass Verbindungsleitungen 59 dazwischen angeordnet sein können. Bevorzugt haben die Verbindungsleitungen 59 eine Länge von maximal 20 cm, bevorzugt maximal 10 cm, besonders bevorzugt maximal 5 cm. In anderen Ausführungsformen (nicht dargestellt) können die Ventilblöcke 11, 12 bzw. zumindest einer der Ventilblöcke 11, 12 unmittelbar an den Wärmetauscher 4 angeschlossen werden. Beispielsweise kann die Seitenfläche 58 entsprechende Anschlussstutzen aufweisen, welche in die jeweilige Öffnung des jeweiligen Ventilblocks 11, 12 geschoben werden, wonach eine fluiddichte Verbindung beispielsweise durch Löten hergestellt werden kann. Der Abstand zwischen dem Wärmetauscher 4 und dem jeweiligen Ventilblock 11, 12 kann damit reduziert werden, gegebenenfalls auf im Wesentlichen 0 cm reduziert werden.

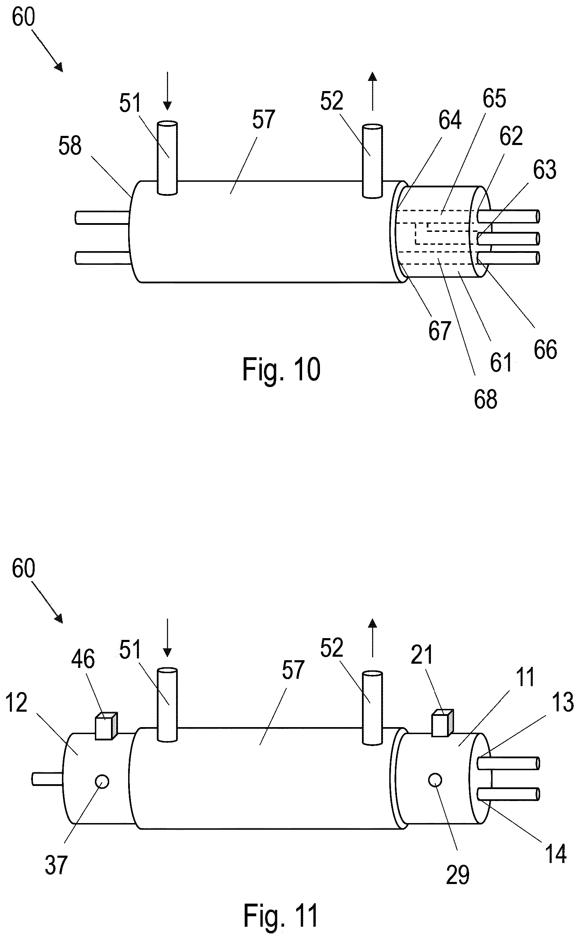

Figur 10 zeigt eine besonders raumsparende Ausführungsform für einen neuartigen Wärmetauscher 60, bei dem eine Seitenfläche durch einen Anschlussblock 61 gebildet wird. Die andere Seitenfläche kann als ebene Platte wie die Seitenfläche 58 des bekannten Wärmetauschers 4 gebildet werden. Der Wärmetauscher 60 umfasst somit einen Anschlussblock 61, einen Mantel 57 und eine ebene Platte. Der Mantel 57 ist fluiddicht mit dem Anschlussblock 61 verbunden, z.B. an diesen angeschweißt. Der Anschlussblock 61 kann am Eingangsende oder am Ausgangsende des Wärmetauschers 60 vorgesehen werden. Alternativ kann der Wärmetauscher 60 auch auf beiden Seiten einen Anschlussblock 61 aufweisen, welche fluiddicht mit dem Mantel 57 verbunden sind.

Der Anschlussblock 61 ist als einstückiger Anschlussblock ausgebildet, der zumindest zwei Außenöffnungen 62, 63 für Kryofluid und zumindest eine Innenöffnung 64 für Kryofluid aufweist, die im Inneren des einstückigen Anschlussblocks 61 durch einen Verbindungsdurchgang 65 verbunden sind. Die Außenöffnungen 62, 63 sind von außen zugänglich, z.B. für den zumindest mittelbaren (über Ventile etc.) Anschluss der Entnahmeleitungen 9, 10, wenn der Anschlussblock 61 dem Kryobehälter 1 in Entnahmerichtung zugewandt ist, oder für den Anschluss einer zum Motor geführten Leitung bzw. einer zum inneren Wärmetauscher 34 geführten Leitung. Die Innenöffnung 64 ist mit dem ersten Wärmetauscherrohr 49 verbunden.

Der Anschlussblock 61 kann somit im einfachsten Fall ein T-Stück ausbilden. Der Anschlussblock 61 kann jedoch auch zumindest eine weitere Außenöffnung 66 und zumindest eine weitere Innenöffnung 67 aufweisen, die im Inneren des einstückigen Anschlussblocks 61 durch einen weiteren Verbindungsdurchgang 68 verbunden sind, wobei der erstgenannte Verbindungsdurchgang 65 und der weitere Verbindungsdurchgang 68 nicht in Verbindung stehen.

Somit muss der Anschlussblock 61 keine nach außen offene Ventilausnehmung aufweisen bzw. kein Ventil aufnehmen können. Tut er dies doch, wird er in der Regel als Ventilblock bezeichnet und kann wie der oben beschriebene Economizer-Ventilblock 11 oder wie der Druckmanagement-Ventilblock 12 ausgebildet sein. Wenn der Anschlussblock 61 den Economizer-Ventilblock 11 bildet, entsprechen die Außenöffnungen 62, 63 der ersten bzw. zweiten Eingangsöffnung 13, 14 und die Innenöffnung 64 entspricht der Ausgangsöffnung 15. Wenn der Anschlussblock 61 den Druckmanagement-Ventilblock 12 bildet, entsprechen die Außenöffnungen 62, 63 der ersten bzw. zweiten Ausgangsöffnung 37, 38 und die Innenöffnung 64 entspricht der Eingangsöffnung 35.

Bevorzugt weist der Wärmetauscher 60 an einem Ende den oben beschriebenen Economizer-Ventilblock 11 auf und am anderen Ende den oben beschriebenen Druckmanagement-Ventilblock 12, wobei diese Ventilblöcke durch den Mantel 57 verbunden sind. Eine entsprechende Ausführungsform ist in Figur 11 dargestellt. Innerhalb des Mantels 57 können dann das bzw. die Wärmetauscherrohre 49, 50 geführt und vom Wärmetauschmedium umspült werden. Auch wenn die Wärmetauscherrohre 49, 50 in den Figuren zur leichteren Übersichtlichkeit als gerade Rohre dargestellt sind, werden diese üblicherweise als gewundene Rohre ausgeführt, um eine größere Fläche für den Wärmeübergang zu bieten. Das erste Wärmetauscherrohr 49 kann mit der Ausgangsöffnung 15 des Economizer-Ventilblocks 11 und mit der ersten Eingangsöffnung 35 des Druckmanagement-Ventilblocks 12 verbunden sein. Das zweite Wärmetauscherrohr 50 kann mit der weiteren Ausgangsöffnung 30 des Economizer-Ventilblocks 11 und mit der zweiten Eingangsöffnung 36 des Druckmanagement-Ventilblocks 12 verbunden sein.

Um den Mantel 57 fluiddicht mit dem bzw. den Anschlussblöcken 61 zu verbinden, weist der Mantel 57 an seinen Enden bevorzugt eine Innenkontur auf, die der Außenkontur des jeweiligen Anschlussblocks 61 an der Verbindungsstelle zum Mantel 57 entspricht. Dadurch kann der Mantel 57 über den Anschlussblock 61 geführt werden, und der Mantel 57 kann beispielswiese mit einer umlaufenden Schweißnaht fluiddicht am Anschlussblock 61 befestigt werden. Dies ist in den Figuren 10 bis 13 dargestellt.

Alternativ kann der Mantel 57 an zumindest einem Ende auch eine Außenkontur aufweisen, die der der Außenkontur des jeweiligen Anschlussblocks 61 entspricht oder kleiner ist als diese. Auch hier kann eine umlaufende Schweißnaht eingesetzt werden, um den Mantel 57 mit dem bzw. den Anschlussblöcken 61 zu verbinden.

Gemäß der Figuren 10 und 11 weist der Wärmetauscher 60 am Mantel 57 einen Mediumeingang 51 und einen Mediumeingang 52 auf. Gemäß Figur 12 kann jedoch auch vorgesehen werden, dass der Mediumeingang 51 und/oder der Mediumausgang 52 im Anschlussblock 61 vorgesehen sind. Beispielswiese kann einer der Anschlussblöcke 61 sowohl den Mediumeingang 51 als auch den Mediumausgang 52 aufweisen, oder einer der Anschlussblöcke 61 kann den Mediumeingang 51 aufweisen und der andere der Anschlussblöcke 61 den Mediumausgang 52. Auch könnte der Mediumeingang 51 bzw. der Mediumausgang 52 im Mantel 57 angeordnet sein und der entsprechend andere Mediumausgang 52 bzw. Mediumeingang 51 im Anschlussblock 61. Wenn dies bei dem Economizer-Ventilblock 11 bzw. bei dem Druckmanagement-Ventilblock 12 vorgesehen wird, wird der entsprechende Ventilblock einen zusätzlichen Verbindungsdurchgang aufweisen, der nicht mit den anderen Verbindungsdurchgängen verbunden ist. Dies könnte im Übrigen auch vorgesehen werden, wenn ein herkömmlicher Wärmetauscher wie in den Figuren 8 und 9 eingesetzt wird, wobei gegebenenfalls Verbindungsleitungen für das Wärmetauschmedium zwischen dem Ventilblock 11, 12 und dem Wärmetauschmedium vorgesehen werden können.

Grundsätzlich kann der Wärmetauscher 60 mit Anschlussblock 61 auch an einer Endkappe 3 des Kryobehälters 2 angeordnet werden, beispielsweise in einer Lage wie in Figur 1 gezeigt. Wie in Figur 13 gezeigt bietet sich jedoch besonders an, den Wärmetauscher 60 im Wesentlichen parallel zum Kryobehälter 1 bzw. dessen Kryobehältermantel 2 anzuordnen, d.h. eine Längsachse L1 des Kryobehälters 2 liegt parallel zu einer Längsachse L2 des Wärmetauschers 60. Wenn der Kryobehälter 1 mittels Tragkonsolen 69 an einem Fahrzeugrahmen des Fahrzeugs montiert ist, liegt der Wärmetauscher 60 an der oberen Hälfte des Kryobehälters 1 und dem Fahrzeugrahmen abgewandt. Alternativ kann der Wärmetauscher 60 auch auf der dem Fahrzeugrahmen zugewandten Seite liegen, um ggf. bei einem Unfall nicht einem direkten Einschlag ausgesetzt zu sein.

Der Wärmetauscher 60 liegt beispielsweise unmittelbar am Kryobehältermantel 2 an oder in einem Abstand zu diesem und liegt zumindest teilweise zwischen den Endkappen 3, wobei er auch über eine der Endkappen 3 ragen kann, insbesondere wenn diese konvex ausgebildet sind. Besonders bevorzugt liegt der Wärmetauscher 60 zumindest teilweise, bevorzugt vollständig, innerhalb eines kleinstmöglichen, gedachten Quaders, der den Kryobehälter 1 umschreibt.

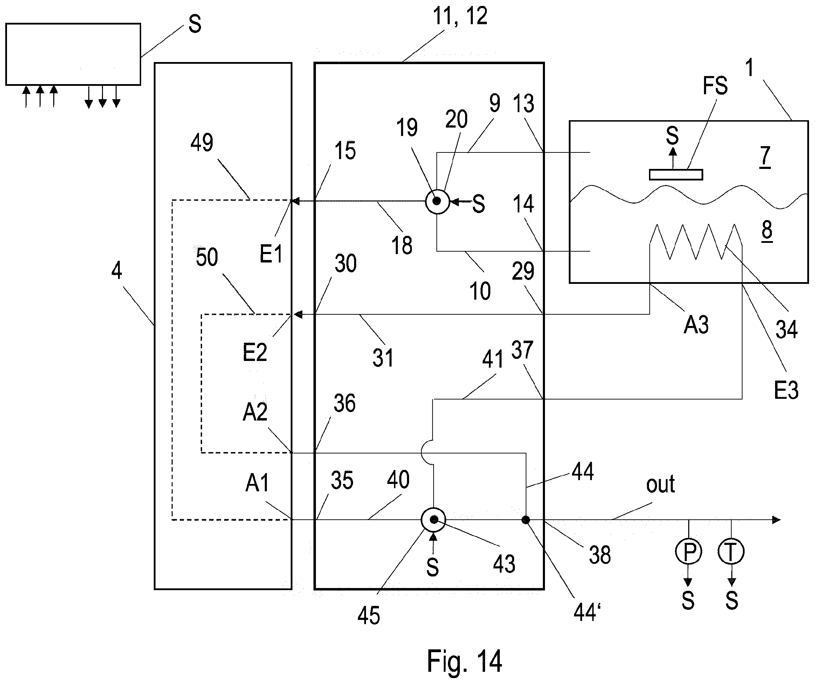

Figur 14 zeigt eine Ausführungsform, bei der ein Ventilblock 11, 12 eingesetzt wird, in dem die Funktionalitäten des Economizer-Ventilblocks 11 und des Druckmanagement-Ventilblocks 12 vereint sind. Es handelt sich somit um einen Ventilblock 11, 12, der eine Eingangsöffnung 13 für eine Leitung zur Entnahme von Kryofluid in Gasphase, eine Eingangsöffnung 14 für eine Leitung zur Entnahme von Kryofluid in Flüssigphase, eine Eingangsöffnung 29 für einen Anschluss an den Ausgang A3 des internen Wärmetauschers 34, eine Ausgangsöffnung 37 für einen Anschluss an den Eingang E3 des internen Wärmetauschers 34 und eine Ausgangsöffnung 38 für die Ausgangsleitung out aufweist. All diese Öffnungen können, müssen aber nicht, an einer gemeinsamen Seite des Ventilblocks 11, 12 angeordnet sein. Weiters weist der Ventilblock 11, 12 eine Ausgangsöffnung 15 für die Eingangsöffnung E1 des ersten Wärmetauscherrohrs 49, eine Eingangsöffnung 35 für die Ausgangsöffnung A1 des ersten Wärmetauscherrohrs 49, eine Ausgangsöffnung 30 für die Eingangsöffnung E2 des zweiten Wärmetauscherrohrs 50 und eine Eingangsöffnung 36 für die Ausgangsöffnung A2 des zweiten Wärmetauscherrohrs 50 auf. Überdies kann der Ventilblock 11, 12 Eingangsöffnungen und Ausgangsöffnungen für Wärmetauschmedium umfassen (nicht dargestellt). Die Verbindungsdurchgänge, Ventilausnehmungen und die optionalen Ausführungsformen sind wie für die Figuren 2 bis 7 beschrieben ausführbar.

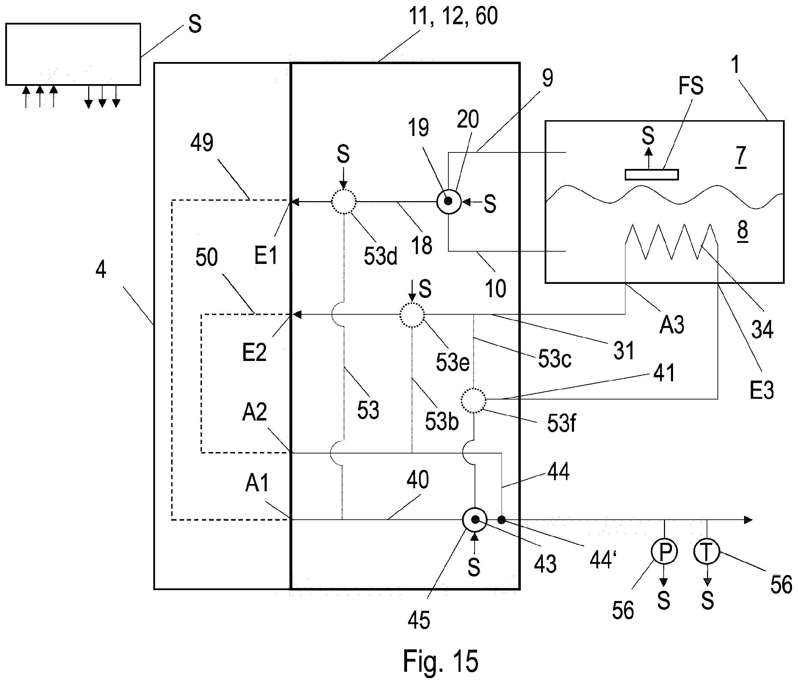

Wie in Figur 15 gezeigt können der Ventilblock 11, 12 und der externe Wärmetauscher 4 voneinander beabstandet und mittels Zwischenleitungen verbunden sein. Alternativ wäre es wie in Figur 15 gezeigt möglich, den Ventilblock 11, 12 unmittelbar und ohne Zwischenleitungen an den externen Wärmetauscher 4 zu montieren bzw. den Ventilblock 11, 12 als Seitenwand im Wärmetauscher zu integrieren, wie hinsichtlich der Figuren 10 bis 13 beschrieben ist.

Zurückkommend auf Figur 7 ist dargestellt, dass zum Parallelschalten der Wärmetauscherrohre 49, 50 bzw. des internen Wärmetauschers 34 wie folgt Überbrückungsleitungen 53a, 53b, 53c vorgesehen werden können:
- eine erste Überbrückungsleitung 53a für das erste Wärmetauscherrohr 49, wobei die erste Überbrückungsleitung 53a vor dem ersten Eingang E1 des ersten Wärmetauscherrohrs 49 an den endseitigen Verbindungsabschnitt 18 oder an eine vom ersten Eingang E1 ausgehende Leitung anschließt und nach dem ersten Ausgang A1 des ersten Wärmetauscherrohrs 49 an den ersten eingangsseitigen Verbindungsabschnitt 40 oder an eine vom ersten Ausgang A1 ausgehende Leitung anschließt;
- eine zweite Überbrückungsleitung 53b für das zweite Wärmetauscherrohr 50, wobei die zweite Überbrückungsleitung 53b vor dem zweiten Eingang E2 an den weiteren Verbindungsdurchgang 31 oder an eine vom zweiten Eingang E2 ausgehende Leitung anschließt und nach dem zweiten Ausgang A2 an den zweiten eingangsseitigen Verbindungsabschnitt 44 oder an eine vom zweiten Ausgang A2 ausgehende Leitung anschließt;
- eine dritte Überbrückungsleitung 53c für den internen Wärmetauscher 34, wobei die dritte Überbrückungsleitung 53c vor dem dritten Eingang E3 an den ersten ausgangsseitigen Verbindungsabschnitt 41 oder an eine vom dritten Eingang E3 ausgehende Leitung anschließt und nach dem dritten Ausgang A3 an den weiteren Verbindungsdurchgang 31 oder an eine vom dritten Ausgang A3 ausgehende Leitung anschließt.

In den Überbrückungsleitungen 53a, 53b, 53c können Ventile 53d, 53e, 53f angeordnet sein, welche gegebenenfalls in Ventilausnehmungen der Ventilblöcke 11, 12 eingesetzt sind. Die Ventile 53d, 53e, 53f können als 2/2-Weg-Ventile in den Überbrückungsleitungen 53a, 53b, 53c ausgebildet sein, wie für das Ventil 53d dargestellt ist, oder als Mehrwegventil an der vorderen oder hinteren Anschlussstelle an die jeweilige Leitung bzw. an den jeweiligen Verbindungsdurchgang, wie für die Ventile 53e, 53f dargestellt ist. Die Ventile 53d, 53e, 53f sind bevorzugt mit der Steuereinheit S verbunden oder können manuell betätigt werden. Die Steuereinheit S kann insbesondere in dieser Ausführungsform mit zumindest einem Sensor zur Bestimmung von Druckmesswerten und/oder Temperaturmesswerten verbunden sein, wobei der Sensor wie oben ausgeführt im Kryobehälter 1, in einem der Ventilblöcke 11, 12 oder in einer an diese angeschlossenen Leitung, insbesondere in der Ausgangsleitung out, angeordnet ist, wobei die Steuereinheit S dazu ausgebildet ist, einen Massenstrom von Kryofluid durch die erste, zweite und/oder dritte Überbrückungsleitung 53a, 53b, 53c in Abhängigkeit der vom Sensor empfangenen Druckmesswerte und/oder Temperaturmesswerte zu steuern, z.B. in dem die Ventile 53d, 53e, 53f entsprechend angesteuert werden.

Die Steuereinheit S kann dazu ausgebildet sein, eine Temperatur stromabwärts des zweiten Knotenpunkts 44', einen Druck stromabwärts des zweiten Knotenpunkts 44' und einen Druck im Kryobehälter 1 zu empfangen oder zu bestimmen und einen Massenstrom über den zweiten eingangsseitigen Verbindungsabschnitt 44, die erste, zweite und/oder dritte Überbrückungsleitung 53a, 53b, 53c unter den Bedingungen zu regeln, dass die Temperatur stromabwärts des zweiten Knotenpunkts 44' bzw. in der Ausgangsleitung out an oder über einer vorbestimmten Mindesttemperatur liegt, der Druck stromabwärts des zweiten Knotenpunkts 44' bzw. in der Ausgangsleitung out an oder über einem vorbestimmten Mindestdruck liegt und der Druck im Kryobehälter 1 minimiert wird. Hierfür kann die Steuereinheit S:
- den Massenstrom durch die erste Überbrückungsleitung 53a oder die zweite Überbrückungsleitung 53b erhöhen, wenn die Temperatur stromabwärts des zweiten Knotenpunkts 44' über einem vorbestimmten Schwellwert liegt;
- den Massenstrom durch die dritte Überbrückungsleitung 53c erhöhen, wenn die Temperatur stromabwärts des zweiten Knotenpunkts 44' unter einem vorbestimmten Schwellwert liegt;
- den Massenstrom an Kryofluid über die erste Überbrückungsleitung 53a erhöhen, wenn der Druck im Kryobehälter 1 oder stromabwärts des zweiten Knotenpunktes 44' unter einem vorbestimmten Schwellwert liegt, wobei die Steuereinheit S bevorzugt dazu ausgebildet ist, eine Bedingung hinsichtlich einer geforderten Mindesttemperatur des Verbrauchers zu lockern oder außer Kraft zu setzten.

Mit den Überbrückungsleitungen 53a, 53b, 53c kann insbesondere auch der Start des Verbrauchers optimiert werden, da sich die Temperatur des Wärmetauschmediums nach dem Start des Verbrauchers verändern wird, d.h. das Wärmetauschmedium zu wird zu Beginn eines Betriebs mit einer ersten Temperatur bereitgestellt und nach einem vorbestimmten Zeitraum nach dem Beginn des Betriebs wird das Wärmetauschmedium mit einer zweiten Temperatur bereitgestellt, die höher ist als die erste Temperatur. Der externe Wärmetauscher 4 kann dazu ausgelegt sein, das Kryofluid zu Beginn des Betriebs bei einer einmaligen Durchführung des Kryofluids durch das erste Wärmetauscherrohr 49 zumindest auf die vorbestimmte Mindesttemperatur des Verbrauchers zu bringen, und die Steuereinheit S kann dazu ausgebildet sein, zu Beginn des Betriebs keinen Massenstrom an Kryofluid über die erste Überbrückungsleitung 53a und/oder die zweite Überbrückungsleitung 53b zu führen, und nach dem vorbestimmten Zeitraum einen Massenstrom an Kryofluid über die erste Überbrückungsleitung 53a und/oder die zweite Überbrückungsleitung 53b zu führen, gegebenenfalls unter der Bedingung, dass die Temperatur stromabwärts des zweiten Knotenpunkts an einer vorbestimmten Mindesttemperatur liegt. Alternativ kann der externe Wärmetauscher 4 dazu ausgelegt sein, das Kryofluid zu Beginn des Betriebs bei einer einmaligen Durchführung des Kryofluids durch das erste Wärmetauscherrohr 49 nur auf eine Temperatur zu bringen, die unter der vorbestimmten Mindesttemperatur eines Verbrauchers liegt, und die Steuereinheit S kann dazu ausgebildet sein, zu Beginn des Betriebs einen Massenstrom an Kryofluid über die dritte Überbrückungsleitung 53c zu führen, und nach dem vorbestimmten Zeitraum keinen Massenstrom an Kryofluid über die dritte Überbrückungsleitung 53c zu führen, gegebenenfalls unter der Bedingung, dass die Temperatur stromabwärts des zweiten Knotenpunkts an einer vorbestimmten Mindesttemperatur liegt.

Wie in Figur 7 dargestellt können die Überbrückungsleitungen 53a, 53b, 53c zumindest oder auch vollständig außerhalb der Ventilblöcke 11, 12 geführt sein, wobei jedoch die Anschlussstelle an den jeweiligen Verbindungsabschnitt innerhalb des Ventilblocks 11, 12 liegt, um wiederum ein außenliegendes T-Stück bzw. Ventil einzusparen. In diesen Ausführungsformen könnte auch nur einer der Ventilblöcke 11, 12 eingesetzt werden.

Figur 15 zeigt eine Ausführungsform, bei der die Überbrückungsleitungen 53a, 53b, 53c vollständig innerhalb eines einzigen Ventilblocks 11, 12 vorgesehen sind, was bei einem Ventilblock wie in Figur 14 gezeigt umsetzbar ist.

Die hierin beschriebene Erfindung betrifft insbesondere die Druckmanagement-Funktionen des Systems, und alle Varianten insbesondere hinsichtlich der Economizer-Funktionen sind lediglich optional und nicht einschränkend, sofern nichts anderen angegeben ist. Insbesondere könnte der Ventilblock der Figuren 13 und 14 beispielsweise auch nur eine der Eingangsöffnungen 13, 14 umfassen, die zur Entnahme von Kryofluid mit dem Kryobehälter 1 verbunden ist, d.h. der Verbindungsdurchgang umfasst nur einen Eingang 13, 14 und nur einen Ausgang 15.

## Patentansprüche

1. System, umfassend einen Kryobehälter (1), insbesondere einen LNG-Behälter oder einen Wasserstoffbehälter, und einen Wärmetauscher (4, 60) mit einem ersten Wärmetauscherrohr (49) für Kryofluid, wobei eine Entnahmeleitung (9, 10) des Kryobehälters (1) mit dem ersten Wärmetauscherrohr (49) des Wärmetauschers (4) verbunden ist,
**dadurch gekennzeichnet, dass**
das System einen einstückigen Druckmanagement-Ventilblock (12) mit zumindest einer ersten Eingangsöffnung (35), einer zweiten Eingangsöffnung (36), einer ersten Ausgangsöffnung (37) und einer zweiten Ausgangsöffnung (38) umfasst, wobei zumindest die erste Eingangsöffnung (35), die erste Ausgangsöffnung (37) und die zweite Ausgangsöffnung (38) im Inneren des einstückigen Druckmanagement-Ventilblocks (12) durch einen Verbindungsdurchgang verbunden sind,
wobei der Verbindungsdurchgang einen ersten eingangsseitigen Verbindungsabschnitt (40), einen ersten ausgangsseitigen Verbindungsabschnitt (41) und einen zweiten ausgangsseitigen Verbindungsabschnitt (42) umfasst, die an einem ersten Knotenpunkt (43) zusammentreffen, wobei der einstückige Druckmanagement-Ventilblock (12) zumindest eine nach außen offene Ventilausnehmung (45) aufweist, wobei die Ventilausnehmung (45) am ersten ausgangsseitigen Verbindungsabschnitt (41), am zweiten ausgangsseitigen Verbindungsabschnitt (42) oder am Knotenpunkt (43) ansetzt,
wobei ein Ventil (46) in die Ventilausnehmung (45) des einstückigen Druckmanagement-Ventilblocks (12) eingesetzt ist, und
wobei das erste Wärmetauscherrohr (49) mit der ersten Eingangsöffnung (36) verbunden ist und die erste Ausgangsöffnung (37) mit einem in den Kryobehälter (1) ragenden weiteren Wärmetauscher (34) verbunden ist, welcher, gegebenenfalls über ein zweites Wärmetauscherrohr des erstgenannten Wärmetauschers (4), mit der zweiten Eingangsöffnung (37) des einstückigen Druckmanagement-Ventilblocks (12) verbunden ist.

2. System nach Anspruch 1, wobei die Ventilausnehmung (45) am Knotenpunkt (43) des Verbindungsdurchgangs ansetzt und das Ventil (46) als Mehrwegventil zwischen dem ersten eingangsseitigen Verbindungsabschnitt (40), dem ersten ausgangsseitigen Verbindungsabschnitt (41) und dem zweiten ausgangsseitigen Verbindungsabschnitt (42) ausgebildet ist.

3. System nach Anspruch 2, wobei das Ventil (46) nur drei Schaltzustände ermöglicht, wobei im ersten Schaltzustand nur die Verbindung zum ersten ausgangsseitigen Verbindungsabschnitt (41) vollständig geschlossen ist, im zweiten Schaltzustand nur die Verbindung zum zweiten ausgangsseitigen Verbindungsabschnitt (42) vollständig geschlossen ist und im dritten Schaltzustand sowohl die Verbindung zum ersten ausgangsseitigen Verbindungsabschnitt (41) als auch zum zweiten ausgangsseitigen Verbindungsabschnitt (42) vollständig geschlossen ist, wobei das Ventil bevorzugt dazu ausgebildet ist, die Verbindung zum ersten ausgangsseitigen Verbindungsabschnitt (41) und die Verbindung zum zweiten ausgangsseitigen Verbindungsabschnitt (42) selektiv zu drosseln.

4. System nach Anspruch 1, wobei der einstückige Druckmanagement-Ventilblock (12) eine erste und eine zweite nach außen offene Ventilausnehmung (47, 48) aufweist, wobei die erste Ventilausnehmung (47) am ersten ausgangsseitigen Verbindungsabschnitt (41) und die zweite Ventilausnehmung (48) am zweiten ausgangsseitigen Verbindungsabschnitt (42) ansetzt, wobei ein erstes Ventil in die erste Ventilausnehmung (47) und ein zweites Ventil in die zweite Ventilausnehmung (48) eingesetzt ist, wobei das erste und das zweite Ventil jeweils Proportionalventile oder Ventile mit diskreten Schaltzuständen sind.

5. System nach einem der Ansprüche 1 bis 4, wobei die zweite Eingangsöffnung (36) innerhalb des Druckmanagement-Ventilblocks (12) über einen zweiten eingangsseitigen Verbindungsabschnitt (44) mit dem zweiten ausgangsseitigen Verbindungsabschnitt (42) verbunden ist.

6. System nach einem der Ansprüche 1 bis 4, wobei der Druckmanagement-Ventilblock (12) eine dritte Ausgangsöffnung (39) umfasst, wobei die zweite Eingangsöffnung (36) innerhalb des Druckmanagement-Ventilblocks (12) über einen weiteren Verbindungsdurchgang (39b) mit der dritten Ausgangsöffnung (39) verbunden ist, wobei der weitere Verbindungsdurchgang (39b) nicht mit dem vorgenannten Verbindungsdurchgang in Verbindung steht.

7. System nach einem der Ansprüche 1 bis 6, wobei der einstückige Druckmanagement-Ventilblock (12) eine weitere nach außen offene Ventilausnehmung (54) aufweist, welche am zweiten endseitigen Verbindungsabschnitt (42) ansetzt, wobei ein Absperrventil in die weitere Ventilausnehmung (42) eingesetzt ist.

8. System nach einem der Ansprüche 1 bis 7, wobei der einstückige Druckmanagement-Ventilblock (12) eine oder mehrere nach außen offene Sensorausnehmungen (55) für einen Sensor (56) aufweist, welche am ersten eingangsseitigen Verbindungsabschnitt (40), am zweiten eingangsseitigen Verbindungsabschnitt (44), am ersten ausgangsseitigen Verbindungsabschnitt (41) und/oder am zweiten ausgangsseitigen Verbindungsabschnitt (42) ansetzen.

9. System nach Anspruch einem der Ansprüche 1 bis 8, wobei der einstückige Druckmanagement-Ventilblock (12) zumindest einen weiteren Verbindungsdurchgang aufweist, der mit keinem der vorgenannten Verbindungsdurchgänge verbunden ist, wobei der weitere Verbindungsdurchgang mit einer Ausgangsleitung für Wärmetauschmedium, mit dem Kryobehälter (1) zur Entnahme von Kryofluid oder mit dem internen Wärmetauscher (34) zur Rückführung von Kryofluid durch ein zweites Wärmetauscherrohr (50) verbunden ist.

10. System nach einem der Ansprüche 1 bis 9, ferner umfassend eine Überbrückungsleitung (53a) zum Parallelschalten des ersten Wärmetauscherrohres (49), eine zweite Überbrückungsleitung (53b) zum Parallelschalten eines zweiten Wärmetauscherrohres des bzw. eines externen Wärmetauschers (4) und/oder eine Überbrückungsleitung (53c) zum Parallelschalten des internen Wärmetauschers (34), wobei zumindest eine der Überbrückungsleitungen (53a, 53b, 53c) innerhalb des Druckmanagement-Ventilblocks (12) mit dem Verbindungsdurchgang oder einem weiteren Verbindungsdurchgang verbunden ist und bevorzugt eine Ventilausnehmung zur Steuerung des Massenstroms über die Überbrückungsleitung (53a, 53b, 53c) vorgesehen ist.

11. System nach einem der Ansprüche 1 bis 10, wobei die erste Eingangsöffnung (35) des einstückigen Druckmanagement-Ventilblocks (12) unmittelbar ohne Zwischenleitung an das erste Wärmetauscherrohr (49) bzw. einen ersten Ausgang des Wärmetauschers (4) angeschlossen ist, wobei der Wärmetauscher (4, 60) bevorzugt ein zweites Wärmetauscherrohr (50) umfasst und wobei die zweite Eingangsöffnung (36) des einstückigen Druckmanagement-Ventilblocks (12) unmittelbar ohne Zwischenleitung an das zweite Wärmetauscherrohr (49) bzw. einen zweiten Ausgang des Wärmetauschers (4) angeschlossen ist.

12. System nach einem der Ansprüche 1 bis 11, wobei der Wärmetauscher (4) stabförmig mit einer Mantelfläche (57) und zwei Seitenflächen (58) ausgebildet ist, wobei der Druckmanagement-Ventilblock (12) in Verlängerung des Wärmetauschers (4) neben einer der Seitenflächen (58) angeordnet ist.

13. System nach einem der Ansprüche 1 bis 12, wobei der Wärmetauscher (60) einen Mantel (57) umfasst, wobei der Druckmanagement-Ventilblock (12) eine der Seitenflächen des Wärmetauschers (60) bildet und ein erstes Ende des Mantels (57) fluiddicht mit dem Druckmanagement-Ventilblock (12) verbunden ist.

14. System nach einem der Ansprüche 1 bis 13, wobei der Kryobehälter (1) einen Kryobehältermantel (2) und zwei Endkappen (3) aufweist, wobei der Wärmetauscher (4, 60) im Wesentlichen parallel zum Kryobehältermantel (2) angeordnet ist und sowohl der Wärmetauscher (4, 60) als auch der Druckmanagement-Ventilblock (12) neben dem Kryobehältermantel (2) zumindest teilweise zwischen den Endkappen (3) liegen, wobei der Wärmetauscher (4, 60) und/oder der Druckmanagement-Ventilblock (12) bevorzugt über eine der Endkappen (3) ragen, wobei zumindest eine, bevorzugt alle der Eingangsöffnungen und/oder Ausgangsöffnungen in Richtung des Fahrzeugrahmens angeordnet sind.

15. System nach einem der Ansprüche 1 bis 14, ferner umfassend eine Steuereinheit (S), welche mit zumindest einem Ventil (46), bevorzugt allen Ventilen (46) des Druckmanagement-Ventilblocks (12) verbunden ist, wobei die Steuereinheit (S) dazu ausgebildet ist, den Massenstrom des über den internen Wärmetauscher zurückgeführten Kryofluids zu steuern und/oder gegebenenfalls den Massenstrom über eine der Überbrückungsleitungen zu steuern, wobei das System bevorzugt ferner zumindest einen Sensor umfasst, der bevorzugt in eine Sensorausnehmung des Druckmanagement-Ventilblocks (13) oder eines Economizer-Ventilblocks (12) eingesetzt ist, wobei die Steuereinheit (S) dazu ausgebildet ist, das bzw. die Ventile (46) in Abhängigkeit eines vom Sensor gelieferten Messwertes zu steuern.

## Claims

1. System comprising a cryogenic container (1), in particular an LNG container or a hydrogen container, and a heat exchanger (4, 60) with a first heat exchanger tube (49) for cryogenic fluid, wherein a withdrawal line (9, 10) of the cryogenic container (1) is connected to the first heat exchanger tube (49) of the heat exchanger (4),
**characterised in that**
the system comprises a single-piece pressure management valve block (12) having at least a first inlet port (35), a second inlet port (36), a first outlet port (37) and a second outlet port (38), wherein at least the first inlet port (35), the first outlet port (37) and the second outlet port (38) are connected inside the single-piece pressure management valve block (12) by a connecting passage,
wherein the connecting passage comprises a first inlet-side connecting section (40), a first outlet-side connecting section (41) and a second outlet-side connecting section (42), which meet at a first node point (43),
wherein the single-piece pressure management valve block (12) has at least one outwardly open valve recess (45), wherein the valve recess (45) is located at the first outlet-side connecting section (41), at the second outlet-side connecting section (42) or at the node point (43),
wherein a valve (46) is inserted into the valve recess (45) of the single-piece pressure management valve block (12), and
wherein the first heat exchanger tube (49) is connected to the first inlet port (36) and the first outlet port (37) is connected to a further heat exchanger (34) which projects into the cryogenic container (1) and which is connected, optionally via a second heat exchanger tube of the first-mentioned heat exchanger (4), to the second inlet port (37) of the single-piece pressure management valve block (12).

2. System according to claim 1, wherein the valve recess (45) is located at the node point (43) of the connecting passage and the valve (46) is designed as a multi-way valve between the first inlet-side connecting section (40), the first outlet-side connecting section (41) and the second outlet-side connecting section (42).

3. System according to claim 2, wherein the valve (46) enables only three switching states, wherein in the first switching state only the connection to the first outlet-side connecting section (41) is completely closed, in the second switching state, only the connection to the second outlet-side connecting section (42) is completely closed, and in the third switching state, both the connection to the first outlet-side connecting section (41) and to the second outlet-side connecting section (42) are completely closed, wherein the valve is preferably designed to selectively throttle the connection to the first outlet-side connecting section (41) and the connection to the second outlet-side connecting section (42).

4. System according to claim 1, wherein the single-piece pressure management valve block (12) has a first and a second outwardly open valve recess (47, 48), wherein the first valve recess (47) is located at the first outlet-side connecting section (41) and the second valve recess (48) is located at the second outlet-side connecting section (42), wherein a first valve is inserted into the first valve recess (47) and a second valve is inserted into the second valve recess (48), wherein the first and second valves are each proportional valves or valves with discrete switching states.

5. System according to any one of claims 1 to 4, wherein the second inlet port (36) within the pressure management valve block (12) is connected to the second outlet-side connecting section (42) via a second inlet-side connecting section (44).

6. System according to any one of claims 1 to 4, wherein the pressure management valve block (12) comprises a third outlet port (39), wherein the second inlet port (36) within the pressure management valve block (12) is connected to the third outlet port (39) via a further connecting passage (39b), wherein the further connecting passage (39b) is not in communication with the aforementioned connecting passage.

7. System according to any one of claims 1 to 6, wherein the single-piece pressure management valve block (12) comprises a further outwardly open valve recess (54), which is attached to the second end-side connecting section (42), wherein a shut-off valve is inserted into the further valve recess (42).

8. System according to any one of claims 1 to 7, wherein the single-piece pressure management valve block (12) comprises one or more outwardly open sensor recesses (55) for a sensor (56), which attach to the first inlet-side connecting section (40), to the second inlet-side connecting section (44), to the first outlet-side connecting section (41) and/or to the second outlet-side connecting section (42).

9. System according to any one of claims 1 to 8, wherein the single-piece pressure management valve block (12) comprises at least one further connecting passage which is not connected to any of the aforementioned connecting passages, wherein the further connecting passage is connected to an outlet line for heat exchange medium, to the cryogenic container (1) for withdrawing cryogenic fluid or to the internal heat exchanger (34) for returning cryogenic fluid through a second heat exchanger tube (50).

10. System according to any one of claims 1 to 9, further comprising a bypass line (53a) for connecting the first heat exchanger tube (49) in parallel, a second bypass line (53b) for connecting a second heat exchanger tube of the or of an external heat exchanger (4) and/or a bypass line (53c) for connecting the internal heat exchanger (34) in parallel, wherein at least one of the bypass lines (53a, 53b, 53c) is connected within the pressure management valve block (12) to the connecting passage or a further connecting passage and preferably a valve recess is provided for controlling the mass flow via the bridging line (53a, 53b, 53c).

11. System according to any one of claims 1 to 10, wherein the first inlet port (35) of the single-piece pressure management valve block (12) is directly connected to the first heat exchanger tube (49) or a first outlet of the heat exchanger (4) without an intermediate line, wherein the heat exchanger (4, 60) preferably comprises a second heat exchanger tube (50) and wherein the second inlet opening (36) of the single-piece pressure management valve block (12) is connected directly to the second heat exchanger tube (49) or a second outlet of the heat exchanger (4) without an intermediate line.

12. System according to one of claims 1 to 11, wherein the heat exchanger (4) is rod-shaped with a shell surface (57) and two side surfaces (58), wherein the pressure management valve block (12) is arranged in extension of the heat exchanger (4) next to one of the side surfaces (58).

13. System according to any one of claims 1 to 12, wherein the heat exchanger (60) comprises a shell (57), wherein the pressure management valve block (12) forms one of the side surfaces of the heat exchanger (60) and a first end of the shell (57) is connected to the pressure management valve block (12) in a fluid-tight manner.

14. System according to any one of claims 1 to 13, wherein the cryogenic container (1) comprises a cryogenic container shell (2) and two end caps (3), wherein the heat exchanger (4, 60) is arranged substantially parallel to the cryogenic container shell (2) and both the heat exchanger (4, 60) and the pressure management valve block (12) are located next to the cryogenic container shell (2) at least partially between the end caps (3), wherein the heat exchanger (4, 60) and/or the pressure management valve block (12) preferably protrude beyond one of the end caps (3), wherein at least one, preferably all, of the inlet openings and/or outlet openings are arranged in the direction of the vehicle frame.

15. System according to any one of claims 1 to 14, further comprising a control unit (S) which is connected to at least one valve (46), preferably all valves (46) of the pressure management valve block (12), wherein the control unit (S) is adapted to control the mass flow of the cryogenic fluid recirculated via the internal heat exchanger and/or optionally to control the mass flow via one of the bypass lines, wherein the system preferably further comprises at least one sensor, which is preferably inserted into a sensor recess of the pressure management valve block (13) or an economiser valve block (12), wherein the control unit (S) is configured to control the valve(s) (46) as a function of a measured value supplied by the sensor.

## Revendications

1. Système comprenant un conteneur cryogénique (1), en particulier un conteneur de GNL ou un conteneur d'hydrogène, et un échangeur de chaleur (4, 60) ayant un premier tube d'échangeur de chaleur (49) pour fluide cryogénique, une conduite de prélèvement (9, 10) du conteneur cryogénique (1) étant reliée au premier tube d'échangeur de chaleur (49) de l'échangeur de chaleur (4),
**caractérisé en ce que**
le système comprend un bloc de vannes de gestion de pression monobloc (12) ayant au moins une première ouverture d'entrée (35), une deuxième ouverture d'entrée (36), une première ouverture de sortie (37) et une deuxième ouverture de sortie (38), au moins la première ouverture d'entrée (35), la première ouverture de sortie (37) et la deuxième ouverture de sortie (38) étant reliées par un passage de raccordement à l'intérieur du bloc de vannes de gestion de pression monobloc (12),
dans lequel le passage de raccordement comprend une première section de raccordement sur le côté d'entrée (40), une première section de raccordement sur le côté de sortie (41) et une deuxième section de raccordement sur le côté de sortie (42) qui se rejoignent à un premier nœud (43),
dans lequel le bloc de vannes de gestion de pression monobloc (12) comporte au moins un évidement de vanne (45) ouvert vers l'extérieur, l'évidement de vanne (45) étant situé au niveau de la première section de raccordement sur le côté de sortie (41), au niveau de la deuxième section de raccordement sur le côté de sortie (42) ou au nœud (43),
dans lequel une vanne (46) est insérée dans l'évidement de vanne (45) du bloc de vannes de gestion de pression monobloc (12), et
dans lequel le premier tube d'échangeur de chaleur (49) est relié à la première ouverture d'entrée (36) et la première ouverture de sortie (37) est reliée à un autre échangeur de chaleur (34) qui fait saillie dans le conteneur cryogénique (1) et qui est relié à la deuxième ouverture d'entrée (37) du bloc de vannes de gestion de pression monobloc (12), éventuellement par l'intermédiaire d'un deuxième tube d'échangeur de chaleur du premier échangeur de chaleur (4).

2. Système selon la revendication 1, dans lequel l'évidement de vanne (45) est situé au nœud (43) du passage de raccordement et la vanne (46) est conçue comme une vanne multivoie entre la première section de raccordement sur le côté d'entrée (40), la première section de raccordement sur le côté de sortie (41) et la deuxième section de raccordement sur le côté de sortie (42).

3. Système selon la revendication 2, dans lequel la vanne (46) ne permet que trois états de commutation, dans lequel, dans le premier état de commutation, seulement le raccordement à la première section de raccordement sur le côté de sortie (41) est complètement fermé, dans le deuxième état de commutation, seulement le raccordement à la deuxième section de raccordement sur le côté de sortie (42) est complètement fermé et, dans le troisième état de commutation, le raccordement à la fois à la première section de raccordement sur le côté de sortie (41) et à la deuxième section de raccordement sur le côté de sortie (42) sont complètement fermés, la vanne étant de préférence conçue pour étrangler sélectivement le raccordement à la première section de raccordement sur le côté de sortie (41) et le raccordement à la deuxième section de raccordement sur le côté de sortie (42).

4. Système selon la revendication 1, dans lequel le bloc de vannes de gestion de pression monobloc (12) comporte un premier et un deuxième évidements de vanne (47, 48) ouverts vers l'extérieur, le premier évidement de vanne (47) étant situé au niveau de la première section de raccordement sur le côté de sortie (41) et le deuxième évidement de vanne (48) étant situé au niveau de la deuxième section de raccordement sur le côté de sortie (42), une première vanne étant insérée dans le premier évidement de vanne (47) et une deuxième vanne étant insérée dans le deuxième évidement de vanne (48), les première et deuxième vannes étant chacune des vannes proportionnelles ou des vannes à états de commutation discrets.

5. Système selon l'une des revendications 1 à 4, dans lequel la deuxième ouverture d'entrée (36) à l'intérieur du bloc de vannes de gestion de pression (12) est reliée à la deuxième section de raccordement sur le côté de sortie (42) via une deuxième section de raccordement sur le côté d'entrée (44).

6. Système selon l'une des revendications 1 à 4, dans lequel le bloc de vannes de gestion de pression (12) comprend une troisième ouverture de sortie (39), la deuxième ouverture d'entrée (36) à l'intérieur du bloc de vannes de gestion de pression (12) étant reliée à la troisième ouverture de sortie (39) par l'intermédiaire d'un autre passage de raccordement (39b), dans lequel l'autre passage de raccordement (39b) n'est pas en communication avec le passage de raccordement précité.

7. Système selon l'une des revendications 1 à 6, dans lequel le bloc de vannes de gestion de pression monobloc (12) comporte un autre évidement de vanne (54) ouvert vers l'extérieur et étant situé au niveau de la deuxième section de raccordement sur le côté d'extrémité (42), une vanne d'arrêt étant insérée dans l'autre évidement de vanne (42).

8. Système selon l'une des revendications 1 à 7, dans lequel le bloc de vannes de gestion de pression monobloc (12) comporte un ou plusieurs évidements de capteur (55) ouverts vers l'extérieur pour un capteur (56), qui sont situé au niveau de la première section de raccordement sur le côté d'entrée (40), au niveau de la deuxième section de raccordement sur le côté d'entrée (44), au niveau de la première section de raccordement sur le côté de sortie (41) et/ou au niveau de la deuxième section de raccordement sur le côté de sortie (42).

9. Système selon l'une des revendications 1 à 8, dans lequel le bloc de vannes de gestion de pression monobloc (12) comporte au moins un autre passage de raccordement qui n'est relié à aucun des passages de raccordement précités, l'autre passage de raccordement étant relié à une conduite de sortie pour le fluide d'échange de chaleur, au conteneur cryogénique (1) pour le prélèvement de fluide cryogénique ou à l'échangeur de chaleur interne (34) pour le retour de fluide cryogénique par un deuxième tube d'échangeur de chaleur (50).

10. Système selon l'une des revendications 1 à 9, comprenant en outre une conduite de pontage (53a) pour mettre en parallèle le premier tube d'échangeur de chaleur (49), une deuxième conduite de pontage (53b) pour mettre en parallèle un deuxième tube d'échangeur de chaleur de l'échangeur de chaleur externe ou d'un échangeur de chaleur externe (4) et/ou une conduite de pontage (53c) pour mettre en parallèle l'échangeur de chaleur interne (34), au moins une des conduites de pontage (53a, 53b, 53c) à l'intérieur du bloc de vannes de gestion de pression (12) étant reliée au passage de raccordement ou à un autre passage de raccordement et, de préférence, un évidement de vanne étant prévu pour réguler le débit massique via la conduite de pontage (53a, 53b, 53c).

11. Système selon l'une des revendications 1 à 10, dans lequel la première ouverture d'entrée (35) du bloc de vannes de gestion de pression monobloc (12) est raccordée directement sans conduite intermédiaire au premier tube d'échangeur de chaleur (49) ou respectivement à une première sortie de l'échangeur de chaleur (4), l'échangeur de chaleur (4, 60) comprenant de préférence un deuxième tube d'échangeur de chaleur (50) et la deuxième ouverture d'entrée (36) du bloc de vannes de gestion de pression monobloc (12) étant raccordée directement sans conduite intermédiaire au deuxième tube d'échangeur de chaleur (49) ou respectivement à une deuxième sortie de l'échangeur de chaleur (4).

12. Système selon l'une des revendications 1 à 11, dans lequel l'échangeur de chaleur (4) est réalisé en forme de barre avec une surface d'enveloppe (57) et deux surfaces latérales (58), le bloc de vannes de gestion de pression (12) étant disposé dans un prolongement de l'échangeur de chaleur (4) à côté d'une des surfaces latérales (58).

13. Système selon l'une des revendications 1 à 12, dans lequel l'échangeur de chaleur (60) comprend une enveloppe (57), le bloc de vannes de gestion de pression (12) formant l'une des surfaces latérales de l'échangeur de chaleur (60) et une première extrémité de la enveloppe (57) étant reliée au bloc de vannes de gestion de pression (12) de manière étanche aux fluides.

14. Système selon l'une des revendications 1 à 13, dans lequel le conteneur cryogénique (1) comporte une enveloppe de conteneur cryogénique (2) et deux embouts (3), l'échangeur de chaleur (4, 60) étant disposé sensiblement parallèlement à l'enveloppe de conteneur cryogénique (2) et l'échangeur de chaleur (4, 60) ainsi que le bloc de vannes de gestion de pression (12) à côté de l'enveloppe de conteneur cryogénique (2) se trouvant au moins partiellement entre les embouts (3), l'échangeur de chaleur (4, 60) et/ou le bloc de vannes de gestion de pression (12) de préférence dépassant d'un des embouts (3), au moins une, de préférence l'ensemble des ouvertures d'entrée et/ou des ouvertures de sortie étant disposées en direction du châssis du véhicule.

15. Système selon l'une des revendications 1 à 14, comprenant en outre une unité de commande (S) qui est reliée à au moins une vanne (46), de préférence à toutes les vannes (46) du bloc de vannes de gestion de pression (12), l'unité de commande (S) étant conçue pour réguler le débit massique du fluide cryogénique renvoyé via l'échangeur de chaleur interne et/ou éventuellement pour réguler le débit massique via l'une des conduites de pontage, le système comprenant en outre de préférence au moins un capteur qui, de préférence, est inséré dans un évidement de capteur du bloc de vannes de gestion de pression (13) ou d'un bloc de vannes d'économiseur (12), l'unité de commande (S) étant conçue pour réguler la ou les vannes (46) en fonction d'une valeur de mesure fournie par le capteur.
